(19) Europäisches Patentamt
European Patent Office
Office européen des brevets

(11) **EP 2 509 117 A1**

(12) **EUROPEAN PATENT APPLICATION**
published in accordance with Art. 153(4) EPC

(43) Date of publication:
**10.10.2012 Bulletin 2012/41**

(51) Int Cl.:
***H01L 31/052*** (2006.01)   ***H01L 31/042*** (2006.01)

(21) Application number: **10833415.2**

(86) International application number:
**PCT/JP2010/071380**

(22) Date of filing: **30.11.2010**

(87) International publication number:
**WO 2011/065571 (03.06.2011 Gazette 2011/22)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.11.2009 JP 2009271152
09.12.2009 JP 2009279733**

(71) Applicant: **Kyocera Corporation
Kyoto-shi
Kyoto 612-8501 (JP)**

(72) Inventors:
• **NIIRA, Koichiro
Higashiomi-shi
Shiga 527-8555 (JP)**

• **ITO, Norikazu
Higashiomi-shi
Shiga 527-8555 (JP)**
• **OKUI, Hiroki
Higashiomi-shi
Shiga 527-8555 (JP)**
• **INABA, Shinichiro
Higashiomi-shi
Shiga 527-8555 (JP)**

(74) Representative: **Witte, Weller & Partner
Königstrasse 5
70173 Stuttgart (DE)**

(54) **PHOTOELECTRIC CONVERSION MODULE, METHOD FOR MANUFACTURING SAME, AND POWER GENERATION DEVICE**

(57)    A photoelectric conversion module comprises: a substrate 61 having a first surface 61a on which a light is incident and a second surface 61b located at the opposite side of the first surface 61 a; a photoelectric conversion element provided on the second surface 61b of the substrate 61; a light-transmitting member 66 provided on the photoelectric conversion element; and a reflecting member 67 provided on the light-transmitting member 66 and configured to reflect a light having transmitted through the light-transmitting member 66. The reflecting member 67 comprises an inclined light reflection surface 67a that allows a light reflected from the reflecting member 67 to be totally reflected at the first surface 61a of the substrate 61.

F I G . 1

**Description**

TECHNICAL FIELD

The present invention relates to a photoelectric conversion module such as a solar cell, an optical sensor, or the like, relates to a method for manufacturing the same, and also relates to a power generation device.

BACKGROUND ART

In recent years, energy issues and environmental issues are getting more serious, and accordingly a photovoltaic power generation using a photoelectric conversion module is attracting attention.

The photoelectric conversion module converts an incident light into electrical energy by means of a photoelectric conversion element, thus generating electric power. In such a photovoltaic power generation, for further prevalence thereof, an increase in the photoelectric conversion efficiency is expected.

An important factor in the improvement of the photoelectric conversion efficiency is a light confinement structure that enables the photoelectric conversion element to efficiently absorb a light incident on the photoelectric conversion module (see Patent Documents 1 to 5 listed below).

PRIOR-ART DOCUMENTS

PATENT DOCUMENTS

Patent Document 1: Japanese Patent Application Laid-Open No. 2-106077 (1990)
Patent Document 2: Japanese Patent Application Laid-Open No. 5-75154 (1993)
Patent Document 3: Japanese Patent Application Laid-Open No. 7-131040 (1995)
Patent Document 4: Japanese Patent Application Laid-Open No. 2002-299661
Patent Document 5: Japanese Patent Application Laid-Open No. 2003-298088

SUMMARY OF THE INVENTION

PROBLEMS TO BE SOLVED BY THE INVENTION

However, in a case where, in a light incident on the photoelectric conversion module, there is a light (especially, a light having a long wavelength) that is reflected at the back surface side of the photoelectric conversion element and then emitted from a light-receiving surface of the photoelectric conversion module to the outside and therefore is lost, the light use efficiency (that is proportional to the energy conversion efficiency) is lowered.

For example, in a photoelectric conversion module using a photoelectric conversion element of crystalline silicon, since crystalline silicon has a high sensitivity even in an infrared region with a wavelength of 700 nm or more, it is important to make efficient use of an emitted light that might be lost because of emission to the outside of the photoelectric conversion module. Thus, how to reduce a light emitted from the photoelectric conversion module, in other words, how to efficiently confine the incident light in the photoelectric conversion module for the contribution to photoelectric conversion, is important.

Moreover, it is demanded that the thickness of a silicon wafer serving as a substrate of a solar cell element be reduced to thereby avoid fluctuations in price associated with the state of supply and demand of a silicon feedstock, so that power can be efficiently generated even with a small amount of silicon. Accordingly, a technique is desired for making an unwasted use of a light that is transmitted through the substrate due to the reduction in the thickness of the substrate and a light that might be lost because it is reflected at the back surface side of the solar cell module and then emitted from the light-receiving surface of the solar cell module to the outside.

An object of the present invention is to provide a photoelectric conversion module in which a light reflected at the back surface side of a photoelectric conversion element is totally reflected at the light-receiving surface side of the photoelectric conversion module so that an incident light is effectively used, to thereby improve the photoelectric conversion efficiency (energy conversion efficiency), a method for manufacturing the same, and a power generation device.

MEANS FOR SOLVING THE PROBLEMS

A photoelectric conversion module according to one embodiment of the present invention comprises: a light-transmitting substrate including a first surface on which a light is incident and a second surface located at the opposite side of the first surface; a photoelectric conversion element positioned on the second surface; a light-transmitting member positioned on the photoelectric conversion element; and a reflecting member positioned on the light-transmitting member and configured to reflect a light having been transmitted through the light-transmitting member. In order to cause a light reflected from the reflecting member to be totally reflected at the first surface of the substrate, the reflecting member comprises a light reflection surface with a concavo-convex shape that is provided with a plurality of chevron-shaped surfaces each inclined at a predetermined angle relative to the first surface.

In order to cause a light reflected from the reflecting member to be totally reflected at the first surface of the substrate, the reflecting member may comprise a light reflection surface with a concavo-convex shape that is provided with a plurality of curved concave surfaces or curved convex surfaces.

In a method for manufacturing a photoelectric conversion module according to one embodiment of the present invention, the light reflection surface is formed by means of transfer to the reflecting member by using a mold.

A power generation device according to one embodiment of the present invention comprises, as power generation means, one or more the photoelectric conversion modules.

## EFFECTS OF THE INVENTION

In the above-mentioned configuration, among incident lights, a light transmitted through the photoelectric conversion element to the back side thereof can be reflected at a further back side of the photoelectric conversion element, and moreover can be totally reflected at a surface of the light-receiving surface side and made incident on the photoelectric conversion element again. This enhances a light confinement effect, to make it possible to provide a photoelectric conversion module and a power generation device having an enhanced photoelectric conversion efficiency.

## BRIEF DESCRIPTION OF THE DRAWINGS

[FIG. 1] A schematic cross-sectional view showing reflection and refraction at a time when a light reflected at a back surface of a photoelectric conversion element reaches a surface of a light-transmitting substrate.

[FIG. 2] (a) shows a result of a simulation in a case where a concavo-convex structure has flat slopes, about a reflectance (internal reflectance) of a light-receiving surface of a module with respect to an angle $\theta$ that is formed by the slopes, and (b) is a schematic cross-sectional view showing a state of light reflection at a light reflection surface.

[FIG. 3] A graph showing the relationship between a refractive index and an angle of a light-transmitting member.

[FIG. 4] A graph showing the relationship between the concavo-convex pitch /radius of curvature and a reflectance.

[FIG. 5] (a) is a schematic cross-sectional view showing the relationship between an incident light and a reflected light at the light reflection surface, and (b) and (c) are cross-sectional views each schematically showing a situation where lights scatter at points on the light reflection surface in a case where the lights are emitted in the vertical direction.

[FIG. 6] (a) to (c) are polar coordinate displays each showing a result of a simulation for the directivity of light energy of a reflected light reflected from an interface having concavity and convexity.

[FIG. 7] A schematic diagram for explaining a photoelectric conversion element constituting a photoelectric conversion module according to one embodiment of the present invention, which is a plan view as seen from the light-receiving surface side thereof.

[FIG. 8] A schematic diagram for explaining the photoelectric conversion element constituting the photoelectric conversion module according to one embodiment of the present invention, which is a plan view as seen from the back surface side thereof.

[FIG. 9] A cross-sectional view taken along the line A-A of FIG. 7.

[FIG. 10] (a) and (b) are schematic diagrams each for explaining a part of the photoelectric conversion element constituting the photoelectric conversion module according to one embodiment of the present invention, which is an enlarged plan view as seen from the back surface side thereof.

[FIG. 11] A schematic diagram for explaining a structure of the photoelectric conversion element constituting the photoelectric conversion module according to one embodiment of the present invention, which is a plan view as seen from the back surface side thereof.

[FIG. 12] A cross-sectional view taken along the line B-B of FIG. 11.

[FIG. 13] A cross-sectional view schematically explaining a structure of the photoelectric conversion element constituting the photoelectric conversion module according to one embodiment of the present invention.

[FIG. 14] A schematic cross-sectional view for explaining a structure of the photoelectric conversion element constituting the photoelectric conversion module according to one embodiment of the present invention.

[FIG. 15] A schematic diagram for explaining a structure of the photoelectric conversion module according to one embodiment of the present invention, which is a plan view as seen from the light-receiving surface side thereof.

[FIG. 16] A schematic cross-sectional view for explaining the photoelectric conversion module according to one embodiment of the present invention.

[FIG. 17] An enlarged schematic cross-sectional view for explaining the photoelectric conversion module according to one embodiment of the present invention.

[FIG. 18] An enlarged schematic cross-sectional view for explaining the photoelectric conversion module according to one embodiment of the present invention.

[FIG. 19] An enlarged schematic cross-sectional view for explaining the photoelectric conversion module according to one embodiment of the present invention.

[FIG. 20] An enlarged schematic cross-sectional view for explaining the photoelectric conversion module according to one embodiment of the present invention.

[FIG. 21] A perspective view showing an example of a reflecting member constituting the photoelectric conversion module according to one embodiment of the present invention.

[FIG. 22] A perspective view showing an example of the reflecting member constituting the photoelectric conversion module according to one embodiment of the present invention.

[FIG. 23] A partial cross-sectional view showing an example of an interface between the light-transmitting member and the reflecting member constituting the photoelectric conversion module according to one embodiment of the present invention.

[FIG. 24] A micrograph of a surface obtained when a flat-plate glass was processed by reactive ion etching and further processed with an aqueous solution of hydrofluoric acid (HF), of which (a) is a photograph in a case where a time period of the process with the aqueous solution of HF was short, and (b) is a photograph in a case where the time period of the process was long.

[FIG. 25] A schematic cross-sectional view for explaining the photoelectric conversion module according to one embodiment of the present invention.

[FIG. 26] A schematic cross-sectional view for explaining the photoelectric conversion module according to one embodiment of the present invention.

[FIG. 27] A partial cross-sectional view for schematically explaining the photoelectric conversion module according to one embodiment of the present invention.

[FIG. 28] A configuration block diagram for explaining a configuration of a power generation device according to one embodiment of the present invention.

EMBODIMENT FOR CARRYING OUT THE INVENTION

In the following, a photoelectric conversion module according to one embodiment of the present invention, a method for manufacturing the same, and an embodiment of a power generation device will be described with reference to the drawings.

«Basic Embodiment»

Firstly, a basic embodiment of the photoelectric conversion module according to one embodiment of the present invention will be described. Here, the description will be given separately for a case where a crystalline type photoelectric conversion element is used and a case where a thin-film type photoelectric conversion element is used, as a photoelectric conversion element including at least a photoelectric conversion part, in the photoelectric conversion module.

In a case of the crystalline type photoelectric conversion element in which a semiconductor such as single crystal silicon or polycrystalline silicon is adopted as the photoelectric conversion part, for example, the photoelectric conversion element is provided with an anti-reflection film and a surface electrode at the light-receiving surface side of the semiconductor and provided with a passivation film and a back surface electrode at the back surface side of the semiconductor.

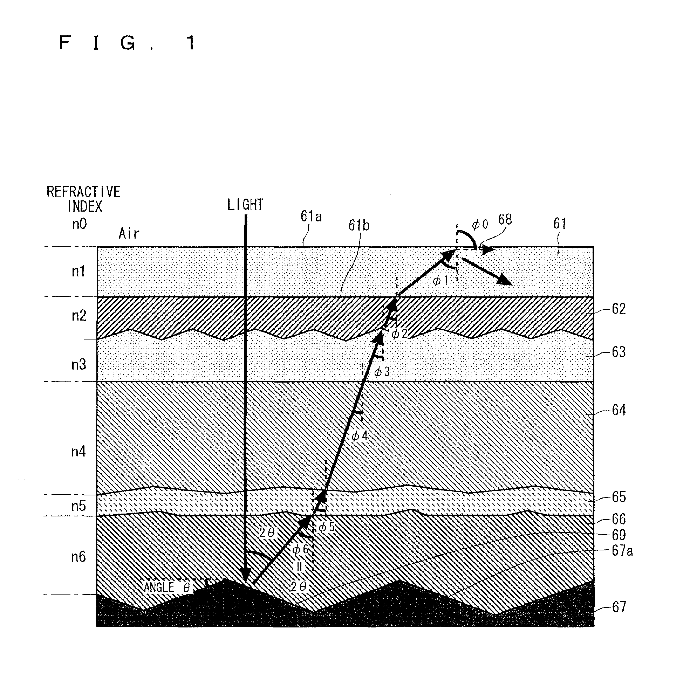

The photoelectric conversion module including this photoelectric conversion element is made, for example, as shown in FIG. 1, in a manner that a light-receiving surface side sealing member which is not shown, a photoelectric conversion element (including a front transparent electrode 62, semiconductors 63 and 64 for example, and a back transparent electrode 65), and a back surface side sealing member exemplified by a light-transmitting member 66 and a reflecting member 67 are integrated by means of, for example, thermal compression bonding including a lamination, onto a second surface 61b of a light-transmitting substrate 61 such as glass having a first surface 61a that is a front surface and the second surface 61b that is a back surface thereof.

In a case where a thin-film type silicon photoelectric conversion element is adopted, in terms of improvement of the conversion efficiency, it is desirable that the light-transmitting member 66 is made of a material transmissive to a light of at least 800 nm. In a case where a crystalline type silicon photoelectric conversion element is adopted, in terms of improvement of the conversion efficiency, it is desirable that the light-transmitting member 66 is made of a material transmissive to a light of at least 950 nm.

An interface (hereinafter, referred to as a reflection interface) 69 between the light-transmitting member 66 and the reflecting member 67 has a repetitive concavo-convex structure. In this concavo-convex structure, an angle θ of an inclined slope that is inclined at a predetermined angle relative to the first surface 61a is controlled to be in a certain angle range in order to allow a light to be totally reflected at the first surface 61a. As shown in FIG. 1, the angle θ of the concavo-convex structure is defined as an angle formed between a plane parallel to the first surface 61 a that is a light-receiving surface of the module and a light reflection surface 67a that is inclined of the reflecting member 67 having the concavo-convex structure.

As described above, the photoelectric conversion module of this embodiment comprises: the light-transmitting substrate 1 having the first surface 61a on which a light is incident and the second surface 61b positioned at the opposite side of the first surface 61a; the photoelectric conversion element positioned on the second surface 61b; the light-transmitting member 66 positioned on the photoelectric conversion element; and the reflecting member 67 positioned on the light-transmitting member 66 for reflecting a light transmitted through the light-transmitting member 66. The reflecting member 67 comprises the light reflection surface 67a having a concavo-convex shape provided with a plurality of chevron-shaped surfaces each having a face inclined at a predetermined angle relative to the first surface 61 a, in order to allow the light reflected at the reflecting member 67 to be totally reflected at the first surface 61a of the light-transmitting substrate 1.

In this photoelectric conversion module, among lights perpendicularly incident on the first surface 61 a from the first surface 61 a, a light having passed through the photoelectric conversion element is reflected at the reflection interface 69 existing in the back surface side sealing member that is arranged at the back surface side of the photoelectric conversion element. This light reflected at the reflection interface 69 can be totally reflected at the first surface 61a at a time when it reaches the first surface 61a of the light-transmitting substrate 1 after passing through the photoelectric conversion element.

In this manner, if the total reflection phenomenon is used to effectively suppress emission of the light (hereinafter, referred to as a back surface reflected light) reflected at the back surface side of the photoelectric conversion element through the first surface 61a to the outside of the module, the incident light is efficiently confined in the photoelectric conversion module. Accordingly, the light use efficiency (photoelectric conversion efficiency) is improved (the photocurrent density is increased), thus improving the energy conversion efficiency.

Hereinafter, a state where the light reflected at the back surface is totally reflected at the light-receiving surface of the module (reflectance=1) will be expressed as, for example, an achievement of TIRAFS, which is created from the first letters of the words "Total Internal Reflection At Front Surface". A state where a light confinement is achieved by the total reflection phenomenon will be expressed as, for example, achieving a totally-reflected-light confinement.

Next, in a case of the thin-film type photoelectric conversion element in which the used photoelectric conversion element adopts a hydrogenated amorphous silicon (hereinafter, abbreviated as a-Si) film, a hydrogenated microcrystalline silicon (hereinafter, abbreviated as μc-Si) film, or the like, the photoelectric conversion element is structured such that a light-receiving surface side transparent electrode, a photoelectric conversion layer made of a-Si or μc-Si, and a back surface side transparent electrode are provided on the light-transmitting substrate. The photoelectric conversion module including this photoelectric conversion element is made by arranging a back surface side sealing member and a back surface member at the back surface side of the back surface side transparent electrode of the photoelectric conversion element and then integrating them by thermal compression bonding of including a lamination, for example. This photoelectric conversion module has a high energy conversion efficiency due to the same principle (the achievement of TIRAFS) as described with respect to the photoelectric conversion module including the crystalline type photoelectric conversion element.

<Method for Achieving TIRAFS>

Next, a more specific description will be given to the principle for exerting an excellent light confinement effect and a method for achieving a TIRAFS condition.

As described above, the concavo-convex structure of the reflection interface 69 formed by the light-transmitting member 66 and the reflecting member 67 has a repetitive concavo-convex shape. Here, by controlling the angle θ of the concavo-convex structure to be in an optimal angle range which will be described next, the light confinement effect can be maximized. That is, when the light reflected at the back surface reaches the light-receiving surface (an interface between the light-transmitting substrate and the air) of the module, the TIRAFS is achieved, and thereby an effective light confinement is achieved, thus improving the energy conversion efficiency of the photoelectric conversion module.

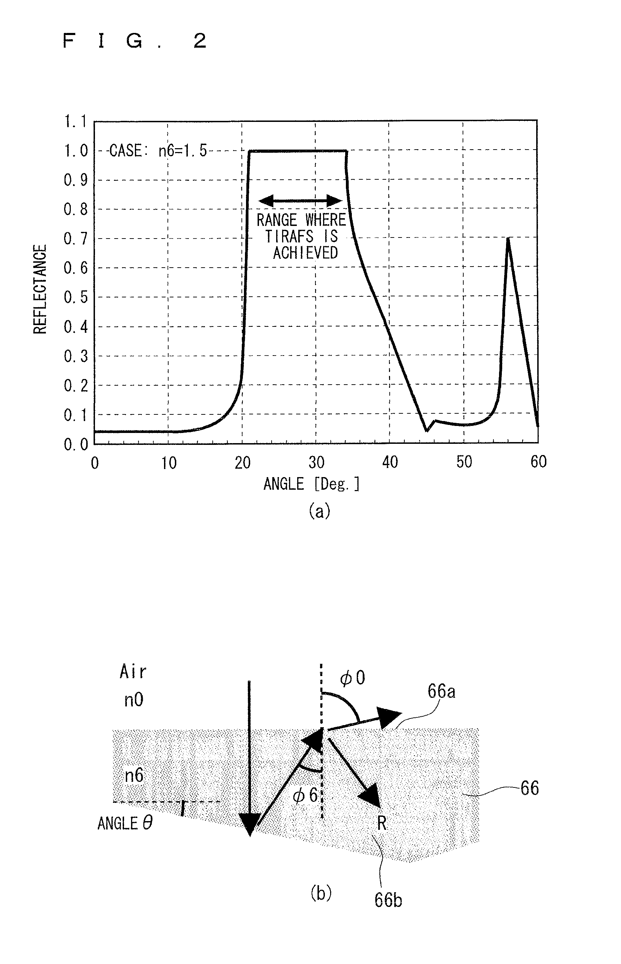

FIG. 2(a) is a diagram showing a result of a simulation in a case where the concavo-convex structure has flat slopes, about a reflectance (internal reflectance) of the light-receiving surface of the module with respect to the angle θ that is formed by the slopes. In this simulation, the light-transmitting member 66 having a refractive index n6 (as a typical value thereof, 1.5 is set) is, at a light-receiving surface 66a thereof, in contact with the air (refractive index n0=1). On the other hand, at an opposite surface 66b thereof, the light-transmitting member 66 is in contact with an imaginary reflecting member having a reflectance of 100%. Thus, a model diagram shown in FIG. 2(b) is set so that an interface (opposite surface 66b) with the imaginary reflecting member has a concavo-convex structure formed with flat slopes.

The model shown in FIG. 2(b) can be considered to be appropriate for the description of the principle of this embodiment, for the following reasons.

First reason is that, as shown in FIG. 1, what a reflection angle or a refraction angle is (including whether or not the total reflection can be caused) when the light reflected at the back surface side of the photoelectric conversion element reaches the first surface 61a of the light-transmitting substrate 61 is not influenced by existence of any medium or any layer between the light-transmitting member 66 and the air existing at the first surface 61a side. Snell's law is sequentially applied to each medium or each interface between layers shown in FIG. 1, as follows:

$$n0 \cdot \sin(0) = n1 \cdot \sin(\phi1);$$

$$n1 \cdot \sin(\phi1) = n2 \cdot \sin(\phi2);$$

$$n2 \cdot \sin(\phi2) = n3 \cdot \sin(\phi3);$$

$$n3 \cdot \sin(\phi3) = n4 \cdot \sin(\phi4);$$

$$n4 \cdot \sin(\phi4) = n5 \cdot \sin(\phi5);$$

$$n5 \cdot \sin(\phi5) = n6 \cdot \sin(\phi6).$$

Therefore, eventually, $n0 \cdot \sin(\phi0) = n6 \cdot \sin(\phi6)$ is established. Here, n1 represents the refractive index of the light-transmitting substrate 61, n2 represents the refractive index of the front transparent electrode 62, n3 represents the refractive index of the semiconductor 63, n4 represents the refractive index of the semiconductor 64, and n5 represents the refractive index of the back transparent electrode 65. Additionally, $\phi6$ represents the angle formed between a reflected light resulting from an incident light perpendicularly incident on the light-transmitting substrate 61 being reflected at the reflecting member 67 and a light beam (hereinafter, a parallel light beam) that is parallel to the aforesaid incident light. $\phi5$ represents the angle formed between the parallel light beam and a light refracted at the back transparent electrode 65. $\phi4$ represents the angle formed between the parallel light beam and a light refracted at the semiconductor 64. $\phi3$ represents the angle formed between the parallel light beam and a light refracted at the semiconductor 63. $\phi2$ represents the angle formed between the parallel light beam and a light refracted at the front transparent electrode 62. $\phi1$ represents the angle formed between the parallel light beam and a light refracted at the light-transmitting substrate 61. In FIG. 1, an arrow 68 indicates an imaginary light traveling direction at a moment when $\phi0$, an angle formed between the parallel light beam and the first surface 61a of the light-transmitting substrate 61, becomes 90°.

Second reason is that, as for the reflectance of the back-surface reflected light at the first surface 61a of the light-transmitting substrate 61, since it can be considered that the refractive index of the light-transmitting member 66 having the reflection interface at the back surface side of the photoelectric conversion element and the refractive index of the light-transmitting substrate 61 at the light-receiving surface side are substantially the same, it is possible to consider that the light-transmitting member 66, instead of the light-transmitting substrate 61, is in contact with the air.

In FIG. 2(b), the relationship between a concavo-convex angle $\theta$ of the light-transmitting member 66 and an incident angle $\phi6$ of incidence of the light reflected at the back surface on the interface between the air and the light-transmitting member 66 is $\phi6=2\theta$, based on a simple geometric relationship. The relationship among the refractive index n0 of the air, the refractive index n6 of the light-transmitting member 66, the refraction angle $\phi0$, and the incident angle $\phi6$ is $n0 \cdot \sin(\phi0)=n6 \cdot \sin(\phi6)$, based on Snell's law.

Particularly, when the TIRAFS is achieved, $\phi0=90°$ is established, and therefore a TIRAFS achievement condition is that $n0 \leq n6 \cdot \sin(\phi6)$. Here, in consideration of the refractive index of the air can be set to be n0=1, $1 \leq n6 \cdot \sin(\phi6)$ is established. Furthermore, solving for $\phi6$ yields that $\phi6 \geq \sin^{-1}(1/n6)$. Here, $\phi6=2\theta$ is established. Eventually, therefore, it can be seen that a requirement for achieving the TIRAFS is that the concavo-convex angle $\theta$ satisfies $\theta \geq 0.5 \cdot \sin^{-1}(1/n6)$.

Here, it should be noted that when the angle $\theta$ is too large, a multiple reflection mode occurs in which reflection is made at the concavo-convex slopes twice or more. As can be easily understood, in this case, the TIRAFS is not necessarily achieved. As a simplest example, a case where the angle $\theta$ is 45° and a case where the angle $\theta$ is 60° can be considered. To be more specific, in a case where the angle $\theta$ is 45°, a double reflection mode occurs so that the light reflected at the back surface is finally perpendicularly incident on the photoelectric conversion layer, and obviously the TIRAFS is not achieved. Likewise, in a case where the angle $\theta$ is 60°, a triple reflection mode occurs so that the light is finally perpendicularly incident on the photoelectric conversion layer in the same manner, and obviously the TIRAFS is not achieved.

In a case where such a concavo-convex structure unintentionally and randomly emerges, the reflectance at the interface between the light-transmitting substrate 61 and the air is less than 50%, and therefore such a case is clearly distinguishable from this embodiment.

In the result shown in FIG. 2(a), these phenomena are taken into consideration. The rapid drop in the reflectance (the situation that the TIRAFS condition is not achieved) at the point where the angle $\theta$ exceeds 35° and therearound is due to occurrence of the multiple reflection mode described above. A sharp peak is caused when the angle $\theta$ is 56° and therearound. This is because a part of the reflected light reflected in the double reflection mode meets a state of the incident angle $\phi6$ that achieves the TIRAFS. However, as clearly seen from the diagram, this angle region is very narrow, and moreover the reflectance is less than 1. Therefore, it is inadequate for fully exerting the TIRAFS.

It can be seen from FIG. 2(a) that, in an example case where the refractive index n6 of the light-transmitting member 66 is about 1.5, the angle $\theta$ formed by the slope of the concavo-convex structure may be in a range of about 20° or more and 35° or less in order to achieve a totally-reflected-light confinement in which the back-surface reflected light reflected at the back surface side of the photoelectric conversion element is totally reflected at the light-receiving surface of the module (in which the reflectance =1 is established, and in other words, in which the TIRAFS is achieved).

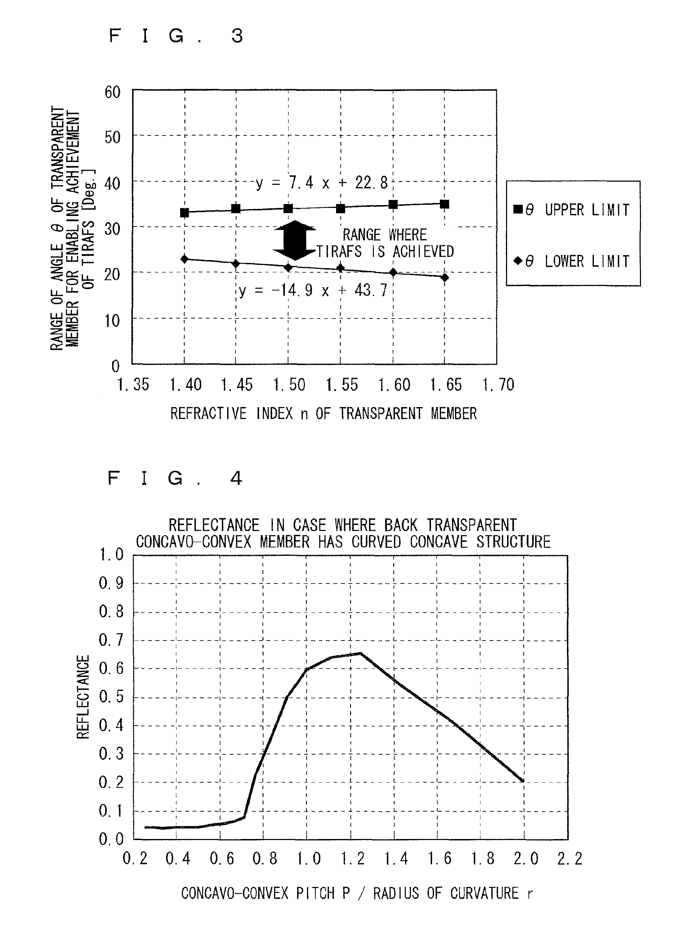

FIG. 3 shows a result of examining such a range of the angle $\theta$ of the concavo-convex structure that the TIRAFS is achieved, in a case where the refractive index n of the light-transmitting member mentioned above is set in a range of about 1.4 or more and 1.65 or less. This clearly shows that the angle $\theta$ formed by the reflection interface (or the light reflection surface 67a) of the concavo-convex structure provided between the light-transmitting member 66 and the reflecting member 67 shown in FIG. 1 falls in an optimal range if the lower limit is set to be [43.7-14.9×n] and the upper limit is set to be [22.8+7.4×n] in accordance with the refractive index n of the light-transmitting member.

In order to maximize the TIRAFS effect, it is desirable that the angle $\theta$ formed by the inclined light reflection surface of the concavo-convex structure falls in the above-mentioned optimal angle range, with respect to any concavo-convex slope. However, needless to say, it is not always required that the angles of all the concavo-convex slopes satisfy the above-mentioned optimal angle range, in order to obtain a substantially significant effect.

Here, as for the shape of the interface of the concavo-convex structure described above, a V-groove-like shape where concavo-convex slopes are flat is the simplest one. However, in a case where the concavo-convex shape is made of a polygonal pyramid with flat slopes, such as a pyramid shape enclosed with four flat faces, the effect can also be sufficiently exerted as long as the angle $\theta$ formed by the flat slope is controlled to be in the optimal angle range mentioned above.

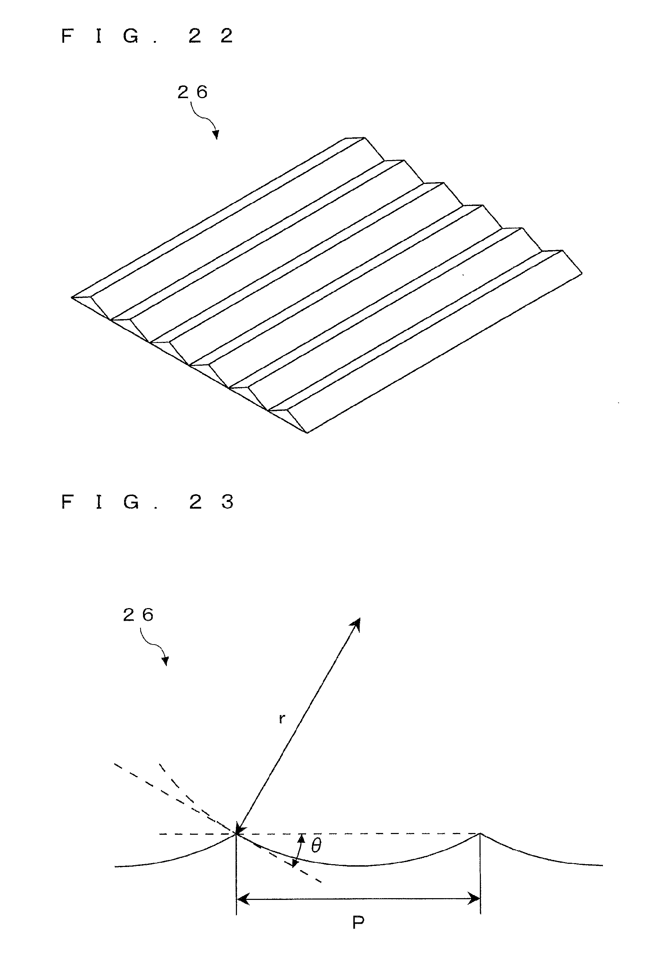

In a case where the concavo-convex structure of the interface (or the light reflection surface 67a) between the light-transmitting member 66 and the reflecting member 67 has such a structure in which a curved surface (dimple type curved surface) recessed downward when seen from the light incident side is repeated, as shown in FIG. 23 which will be described later, the concavo-convex structure is controlled such that the average radius of curvature r forming this curved surface and the average pitch P (average distance between adjacent convex portions) of the concavo-convex shape satisfy a relationship of $0.7 \leq P/r \leq 2.0$, and more preferably, $0.9 \leq P/r \leq 1.5$. Here, for the averaging, five or more portions may be measured and results thereof may be averaged.

Here, the average radius of curvature r is the radius of a circle whose center point is a point where normal lines to tangent planes at each of two different points of the curved surface intersect each other. That is, r is a distance between the center point and the curved surface.

$\theta$ in FIG. 23 represents an angle formed by the above-mentioned curved concave surface. The maximum thereof is referred to as a maximum angle $\theta$max. Table 1 shows the relationship between P/r and the maximum angle $\theta$max of the concavity and convexity formed by the curved concave surface mentioned above.

[Table 1]

| P/r | $\theta$max [degree] |
| --- | --- |
| 2.00 | 90.0 |

(continued)

| P/r | θmax [degree] |
|---|---|
| 1.67 | 56.4 |
| 1.43 | 45.6 |
| 1.25 | 38.7 |
| 1.11 | 33.7 |
| 1.00 | 30.0 |
| 0.91 | 27.0 |
| 0.83 | 24.6 |
| 0.77 | 22.6 |
| 0.71 | 20.9 |
| 0.67 | 19.5 |
| 0.63 | 18.2 |
| 0.59 | 17.1 |
| 0.56 | 16.1 |
| 0.53 | 15.3 |
| 0.50 | 14.5 |
| 0.40 | 11.5 |
| 0.33 | 9.6 |
| 0.29 | 8.2 |
| 0.25 | 7.2 |

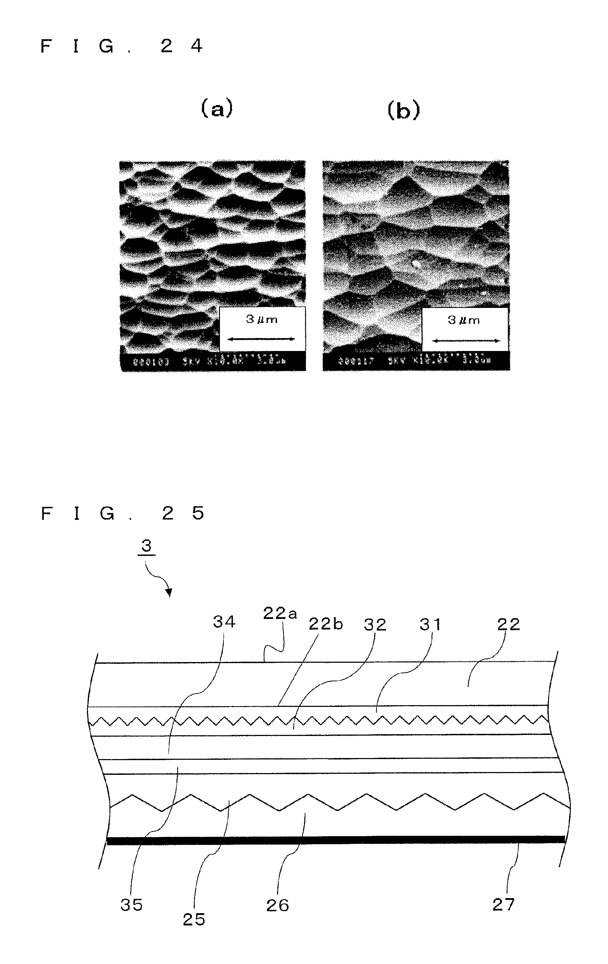

The structure in which the curved concave surface is repeated is not limited to a structure having regular pitches. As in a photograph of an example shown in FIG. 24 which will be described later, a repetitive structure having random pitches may be acceptable. A method for forming a concavo-convex structure shown in FIG. 24 and a method for controlling it will be described later.

FIG. 4 shows a simulated effective reflectance at a light-receiving surface of the module in a case where the concavo-convex structure is constituted by the curved concave surfaces. More specifically, with respect to each of minute portions of the curved surfaces, a reflectance at a light-receiving surface of the module that corresponds to the angle θ formed between a tangent plane of the minute portion and a plane parallel to the light-receiving surface was calculated (since the minute portion of the curved surfaces can be regarded as a flat slope, the reflectance can be calculated in the same manner as a case where the concavo-convex structure is constituted by flat slopes), and the resulting reflectances throughout the entire curved surfaces were summed (integrated).

As clearly seen from FIG. 4, the effective reflectance start to rapidly rise at the point where the average concavo-convex pitch P / radius of curvature r (hereinafter, simply referred to as P/r) is about 0.7 or more. This is because, in a condition that P/r exceeds 0.7, a part of the light reflected at the above-mentioned curved concave surfaces start to satisfy a condition for causing total reflection at the light-receiving surface of the module (conversely, when P/r is less than 0.7, a light reflected at any portion of the curved surfaces is not totally reflected at the light-receiving surface of the module so that a considerable amount of light is emitted through the light-receiving surface to the outside of the module and is lost).

When P/r is in a range of about 1.1 or more and 1.3 or less, the effective reflectance makes its peak. This corresponds to the fact that the percentage of the light totally reflected at the light-receiving surface of the module is highest in the above-mentioned optimal range. That is, this corresponds to a state where the percentage of the light totally reflected at the light-receiving surface of the module in the light reflected at the curved surfaces is highest. However, in a case where the concavo-convex structure is constituted by curved concave surfaces instead of flat slopes, it is impossible that all the light reflected at the curved surfaces is totally reflected at the light-receiving surface of the module. Therefore, the effective reflectance makes its peak in a range less than 1.

At the point where P/r is about 1.2 or more and 1.3 or less, the effective reflectance starts to rapidly drop. This corresponds to the fact that, in the light reflected at the curved surfaces, a component that cannot be totally reflected at the light-receiving surface of the module increases again in accordance with the increase of P/r. This is because of occurrence of the multiple reflection mode.

In the above, the description has been given to, as an example, the concavo-convex structure having the curved concave surfaces recessed downward. However, the same discussion applies to a concavo-convex structure having curved surfaces protruding upward.

The concavo-convex pitch in the concavo-convex structure (including either of a case where the slope is flat and a case where the slope is a concave curved surface or convex curved surface) may be substantially uniformly repeated in a regular manner, or may be randomly repeated.

It assumed that the average pitch P of the concavo-convex structure is sufficiently greater than $\lambda/n$. Here, $\lambda$ represents a wavelength of the light under consideration, and n represents a refractive index of the light-transmitting member 66. As mentioned above, $\lambda$ is a wavelength of a light particularly in a long wavelength region, and specifically, typified by a wavelength of about 800 nm. The refractive index n of the light-transmitting member 66 is typically about 1.5. That is, it is necessary that the average pitch P is at least 800nm/1.5 = 533nm (about $0.5\mu m$), and desirably has a value of about several times or more (about $3\mu m$ or more).

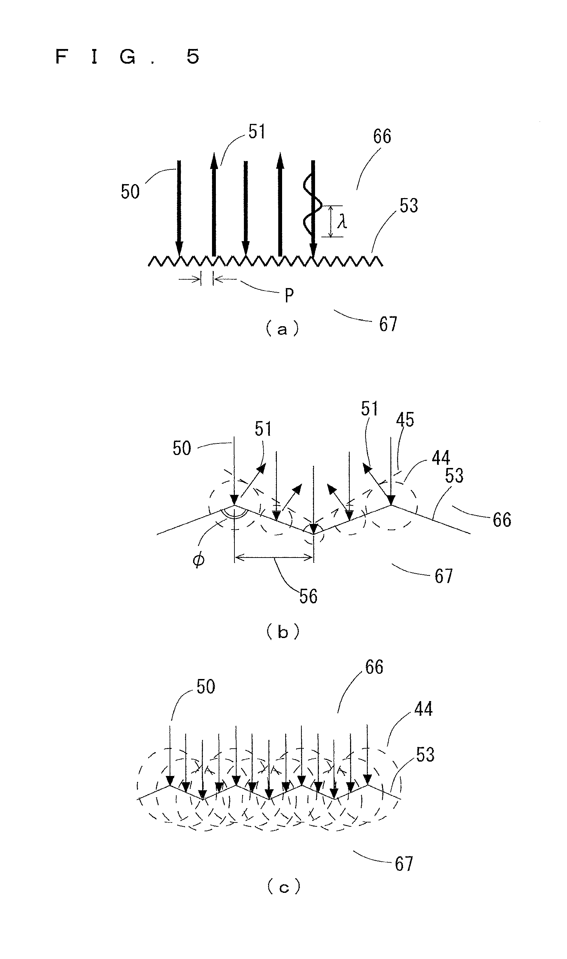

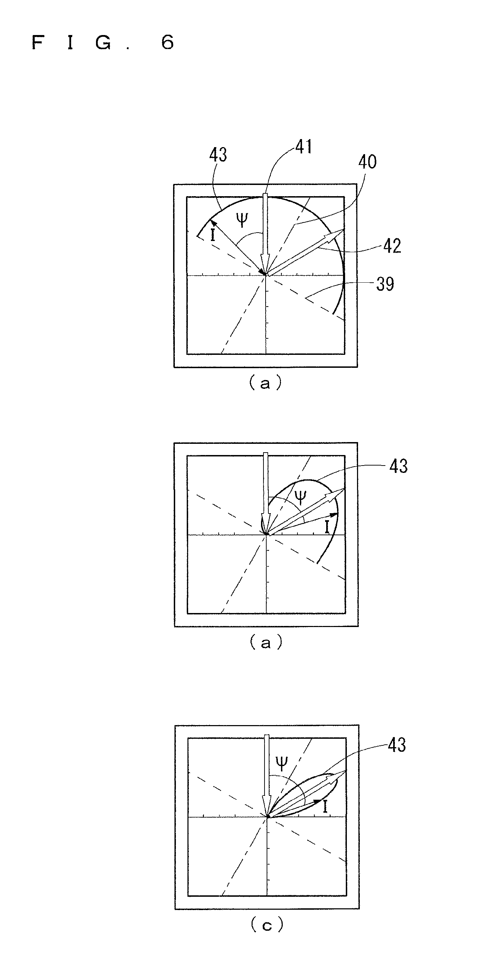

The reason therefor will be described with reference to FIGS. 5 and 6.

In FIG. 5(a), a surface 53 that reflects lights corresponds to the reflection interface formed by the light-transmitting member 66 and the reflecting member 67. In FIG. 5(a), a part above the interface 53 corresponds to the light-transmitting member 66. Accordingly, in the following description, when the wavelength of the incident light 50 in vacuum is defined as $\lambda$ and the refractive index of the light-transmitting member 66 is defined as n, the wavelength $\lambda_1$ of the incident light 50 within the light-transmitting member 66 is $\lambda_1=\lambda/n$ that is a smaller value than that of the wavelength in vacuum.

FIG. 5(b) and FIG. 5(c) are diagrams enlarging the concavo-convex structure shown in FIG. 5(a), and showing a situation where lights scatter at points on the slopes according to Huygens' principle in a case where the lights are emitted in the vertical direction from right above in the illustration.

FIG. 5(b) shows a case where a width 56 (corresponding to 1/2 of the average pitch P) having the average value of horizontal intervals of the concavo-convex structure of the interface 53 is larger than the light wavelength $\lambda_1$, that is, a case where there is no flatness in an optical sense. The lights 50 incident on the respective points on the inclined slopes of the concavo-convex structure start to scatter as spherical waves from the respective points, and form scattering-light wavefronts having the same phase at the respective points on the slopes, as illustrated with dotted lines 44. An envelope surface enveloping these scattering-light wavefronts 44 is illustrated with an dotted line 45. The envelope surface 45 forms a reflected-light wavefront. In this case, a traveling direction of the reflected light 51 is the direction perpendicular to this reflected-light wavefront 45.

FIG. 5(c) shows a case where the width 56 (corresponding to 1/2 of the average pitch P) having the average value of horizontal intervals of the concavo-convex structure of the interface 53 is smaller than the light wavelength $\lambda_1$, that is, a case where there is flatness in an optical sense. As clearly seen from the diagram, an envelope surface enveloping the scattering-light wavefronts 44 formed by the lights 50 incident on the respective points on the slopes of the concavo-convex structure is substantially flat, though there are slight concavity and convexity. That is, a reflected-light wavefront forms a plane that is substantially parallel to a surface obtained by averaging the concavity and convexity of the interface 53. In this case, a traveling direction of the reflected light is the direction perpendicular to the reflected-light wavefront. Eventually, therefore, the incident light is reflected substantially perpendicularly even though it is incident on the concavo-convex surface.

FIG. 6(a) to (c) shows, in the form of polar coordinate displays, a result of simulating and calculating a directivity that indicates the traveling direction and the amount of light energy of the reflected light from the interface 53 having the concavo-convex structure as shown in FIG. 5(b) and FIG. 5(c). That is, it is indicated as a curve 43 in the polar coordinate display using a point $(\Psi,I)$ that is defined by an angle $\Psi$ indicating a direction of the reflected light and an intensity I in the direction thereof. Here, the angle $\phi$ of every apex in the concavity and convexity of the interface 53 is set to be 120° (corresponding to the angle $\theta=30°$ of the concavo-convex slope of the light-transmitting member). FIG. 6(a), FIG. 6(b), and FIG. 6(c) show cases where the average value 56 (corresponding to 1/2 of the average pitch P) of the horizontal intervals of the concavity and convexity is 0.1 times greater than, equal to, and 3 times greater than the light wavelength $\lambda_1$ in the medium, respectively.

In these diagrams, a dotted line 39 indicates the inclination of the slope of the concavity and convexity of FIG. 5(b), an alternate long and short dash line 40 indicates the direction perpendicular to the slope of the concavity and convexity, and an arrow 41 indicates the incident light traveling toward the slope, by which light incidence from right above is shown. An arrow 42 indicates a reflecting direction according to "incident angle = reflection angle".

In FIG. 6(c), it can be found that energy is reflected from the central point with a high directivity in the reflecting direction that is according to "incident angle on the slope = reflection angle". This is due to the fact that the average value 56 (corresponding to 1/2 of the average pitch P) of the horizontal intervals of the concavity and convexity is 3 times greater than the light wavelength $\lambda_1$ in the medium.

In FIG. 6(a), on the other hand, no particular directivity is found. This is due to the fact that the width 56 (corresponding to 1/2 of the average pitch P) having the average value of the horizontal intervals of the concavo-convex structure is 0.1 times greater than the light wavelength $\lambda_1$ in the medium. In other words, it reflects the fact that the concavo-convex structure is optically flat.

Also in FIG. 6(b), it is seen that the directivity is inferior to that of FIG. 6(c). Thus, it can be understood that the case where the width 56 (corresponding to 1/2 of the average pitch P) of the average value of the horizontal intervals of the concavity and convexity is equal to the light wavelength $\lambda_1$ in the medium is inadequate for such an effect that the directivity of the reflected light is controlled.

From the above, it can be understood that, in order that the concavo-convex structure can reflect sufficient light energy in the reflecting direction derived from the inclined slope thereof, it is necessary that at least the average pitch P of the concavo-convex structure is about four times or more greater than the light wavelength $\lambda$ (in vacuum) under consideration (based on P/2 ≥in-medium light wavelength $\lambda_1 \times 3$times; in-medium light wavelength $\lambda_1$ = in-vacuum light wavelength $\lambda$ / refractive index n of light-transmitting member; and typical value of n=1.5). Specifically, it is understood that, when a typical value of the light wavelength $\lambda$ in vacuum takes 800nm=0.8$\mu$m, the average pitch P needs to be at least 3$\mu$m which is four times greater.

Finally, as a material that forms a sealing member including the light-transmitting member and the reflecting member and having a concavo-convex structure at the interface thereof, there may be used, for example, an ethylene-vinyl acetate copolymer (hereinafter, abbreviated as EVA: its refractive index is about 1.52), a polyvinyl alcohol resin (PVA, refractive index: 1.49 or more and 1.53 or less), an acrylic resin (refractive index: about 1.49), a vinyl chloride resin (refractive index: about 1.54), a silicone resin (refractive index: 14.1 or more and 1.43 or less), a polycarbonate resin (refractive index: about 1.59), a polystyrene resin (refractive index: about 1.6), or a vinylidene chloride resin (refractive index: about 1.61), alone or in combination. Here, if a white material such as titanium oxide or a pigment is added to the above-mentioned material or a surface of the reflecting member is coated with, for example, a metal film having a high reflectance, performance for effectively reflecting a light can be given to the reflecting member.

«Specific Embodiment»

<Embodiment 1>

Next, a specific example of the embodiment will be described. In the following example, a crystalline type semiconductor substrate which is a single crystal silicon or a polycrystalline silicon is used in a photoelectric conversion element.

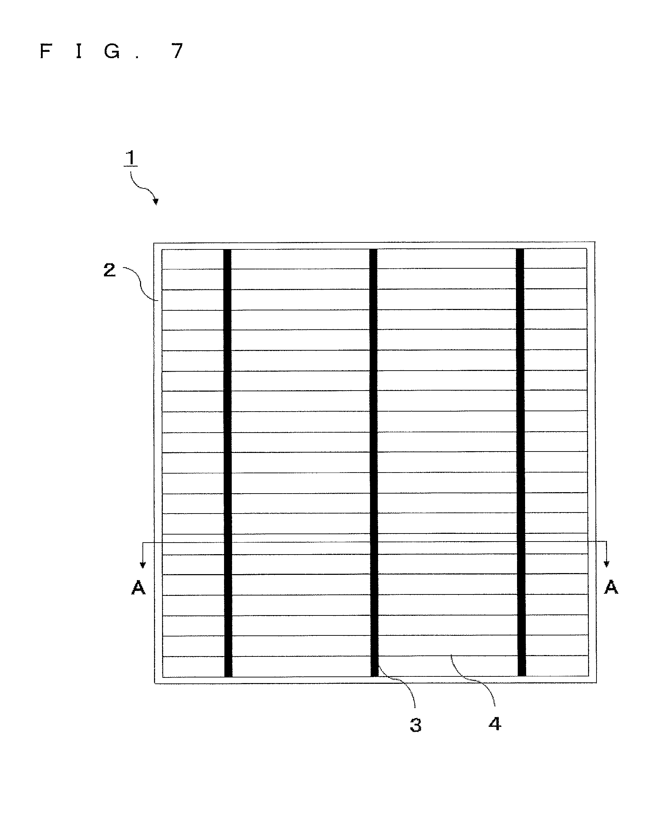

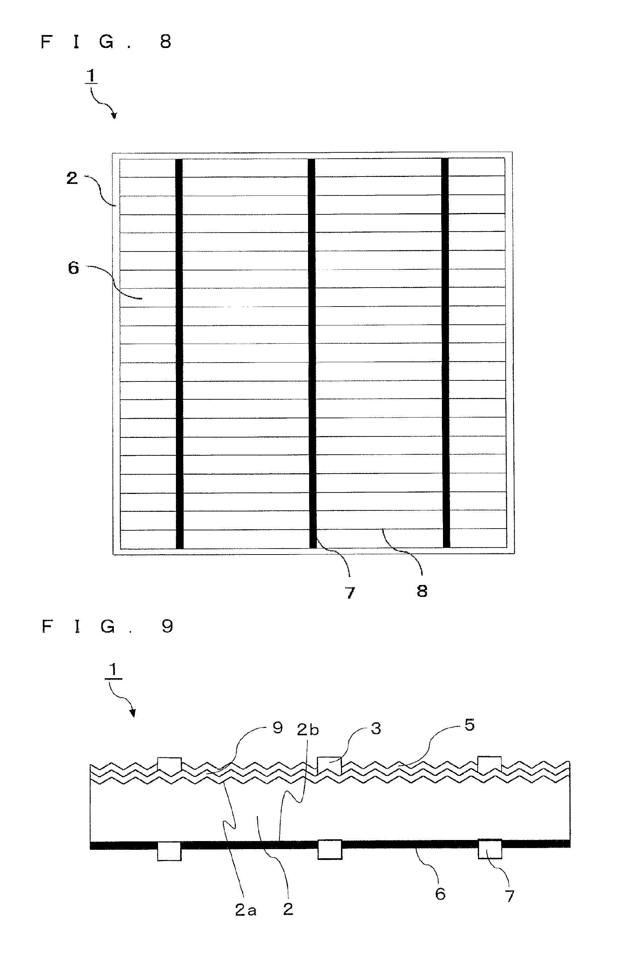

FIGS. 7 to 9 show an example of the crystalline type photoelectric conversion element 1. In these drawings, the reference numeral 2 denotes a semiconductor substrate, the reference numeral 3 denotes a light-receiving surface side bus-bar electrode, the reference numeral 4 denotes a light-receiving surface side finger electrode, the reference numeral 5 denotes an anti-reflection film, the reference numeral 6 denotes a passivation film, the reference numeral 7 denotes a back surface side bus-bar electrode, and the reference numeral 8 denotes a back surface side finger electrode. In FIG. 9 the reference numeral 2a denotes a first surface of the semiconductor substrate 2, and the reference numeral 2b denotes a second surface of the semiconductor substrate 2.

The semiconductor substrate 2 has a function for converting an incident light into electricity. Such a semiconductor substrate 2 is, for example, a crystalline type silicon substrate shaped into a rectangular flat plate of about 150$\mu$m or more and 160mm or less at one side. The semiconductor substrate 2 has a first conductivity type (for example, p-type). A semiconductor layer 9 having a second conductivity type (for example, n-type) is formed on the semiconductor substrate 2 (on the light-receiving surface side surface of the semiconductor substrate 2). A pn junction is formed at an interface between the semiconductor substrate 2 and the semiconductor layer 9.

As shown in FIG. 7, on the light-receiving surface of the semiconductor substrate 2, the light-receiving surface side bus-bar electrodes 3 is formed to have a large width of 1mm or more and 3mm or less and the light-receiving surface side finger electrodes 4 is formed so as to substantially perpendicularly intersect the light-receiving surface side bus-bar electrodes 3, and have a thin width of 50$\mu$m or more and 200$\mu$m or less.

It is desirable to form the anti-reflection film 5 on the light-receiving surface, as shown in FIG. 9. For the anti-reflection film 5, for example, a silicon nitride ($Si_3N_4$), titanium oxide ($TiO_2$), or a silicon oxide ($SiO_2$) may be used. The thickness of the anti-reflection film 5 is appropriately selected in accordance with the refractive index of the above-mentioned material. To be specific, in a case where the refractive index is about 1.8 or more and 2.3 or less, the thickness may be set to be about 50nm or more and 120nm or less. The anti-reflection film 5 can be formed by using a PECVD process, a vapor deposition process, a sputtering process, or the like.

As shown in FIGS. 8 and 9, on back surface (non-light-receiving surface) of the semiconductor substrate 2, the passivation film 6 is formed on the substantially entire surface thereof, and the back surface side bus-bar electrodes 7 and the back surface side finger electrodes 8 are formed. The shapes of the back surface side bus-bar electrodes 7 and the back surface side finger electrodes 8 may be similar to the shapes of the light-receiving surface side bus-bar electrodes 3 and the light-receiving surface side finger electrodes 4 mentioned above.

For the passivation film 6, a Si-based nitride film such as a silicon nitride ($Si_3N_4$) or amorphous Si nitride film (a-SiNx), a Si-based oxide film such as a silicon oxide ($SiO_2$) or amorphous Si oxide film (a-SiOx), a Si-based carbide film such as a silicon carbide (SiC) or amorphous Si carbide film (a-SiCx), a hydrogenated amorphous silicon (a-Si), an aluminum oxide ($Al_2O_3$), titanium oxide ($TiO_2$), or the like, may be used.

A method for manufacturing such a crystalline type photoelectric conversion element 1 is as follows.

Firstly, the semiconductor substrate 2 is prepared. The semiconductor substrate 2 exhibits a p-type conductivity by containing boron (B), for example, and is a single crystal silicon substrate made by a pulling process such as the Czochralski process or a polycrystalline type silicon substrate made by a casting process or the like.

Furthermore, the semiconductor substrate 2 is made by slicing a silicon ingot having a size of about 150mm squares or more and 160mm squares or less into a thickness of $350\mu m$ or less, and more preferably into a thickness of $200\mu m$ or less, by using a wire saw or the like. It is preferable that a concavo-convex (roughened) structure having a light-reflectance reduction function is formed on the light-receiving surface of the semiconductor substrate 2 by using a dry etching process, a wet etching process, or the like.

Then, phosphorus (P) that serves as a doping element for promoting the exhibition of n-type is diffused in the semiconductor substrate 2, to thereby form the n-type semiconductor layer 9. As a result, a pn junction portion is formed between the semiconductor substrate 2 and the semiconductor layer 9.

The n-type semiconductor layer 9 is formed by, for example, the following processes: an application and thermal diffusion process where, while the semiconductor substrate 2 is kept at a temperature raised up to about 700°C or more and 900°C or less, phosphorus pentoxide ($P_2O_5$ in the form of a paste is applied to the surface of the semiconductor substrate 1 and thermally diffused, or a vapor phase thermal diffusion process which is a process under an atmosphere of phosphorus oxychloride ($POCl_3$) in a gas state as a diffusion source and at 700°C or more and 900°C or less for about 20 minutes or more and 40 minutes or less. Thereby, the n-type layer is formed with a depth of about $0.2\mu m$ or more and $0.7\mu m$ or less.

Then, the anti-reflection film 5 is formed at the light-receiving surface side of the semiconductor substrate 2, and the passivation film 6 is formed on the back surface thereof. The anti-reflection film 5 and the passivation film 6 can be formed by using a PECVD process, a vapor deposition process, a sputtering process, or the like.

Then, the light-receiving surface bus-bar electrodes 3 and the light-receiving surface finger electrodes 4 are formed on the n-type semiconductor layer 9, and the back surface side bus-bar electrodes 7 and the back surface side finger electrodes 8 are formed on the semiconductor substrate 2, in such a manner that an electrical contact is established. These electrodes are formed by, for example, applying a conductive paste containing silver as a main component in a predetermined pattern of electrodes and then baking it up to a maximum temperature of 600°C or more and 850°C or less for about several seconds to several minutes. As a method for the application, for example, a screen printing process may be adopted. It may be acceptable to preliminarily remove parts of the anti-reflection film 5 and the passivation film 6 located in regions where the above-mentioned electrodes and the semiconductor substrate 2 are connected to each other. Alternatively, it may be acceptable to, without such removal, connect the above-mentioned electrodes and the semiconductor substrate 2 to each other by the fire-through process.

Although the formation of the electrodes by the printing and baking process has been described above, a thin-film formation process such as vapor deposition or sputtering, a plating process, or the like, can form the electrodes under a condition of a relatively low temperature as compared with the baking process. In this case, the above-mentioned parts of the anti-reflection film 5 or the passivation film 6 located in the regions where the electrical contact occurs can be preliminarily removed. For the formation of the electrical contact of the surface side electrodes, the light-receiving surface bus-bar electrodes 3 and the light-receiving surface finger electrodes 4 are formed by printing and then caused to penetrate through the anti-reflection film 5 by means of the fire-through process, and thereby can be brought into electrical contact with the n-type semiconductor layer 9. For the formation of the regions where the electrical contact of the back surface side electrode occurs, the back surface side electrodes are formed on the passivation film 6 and then a laser beam is emitted to thereby melt parts of the back surface side electrodes so that a metal component constituting the electrodes penetrates through the passivation film 6, to be brought into electrical contact with the semiconductor substrate 2.

For example, the following structure is also acceptable.

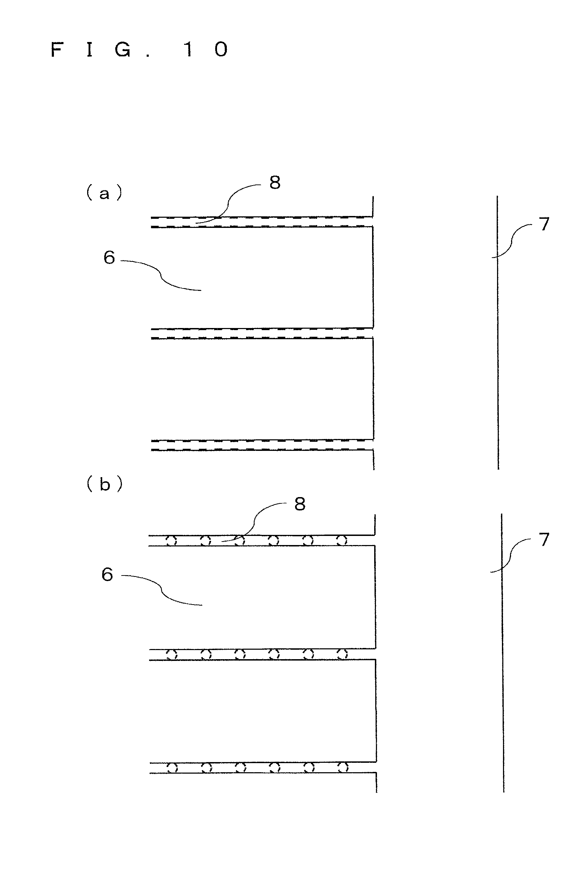

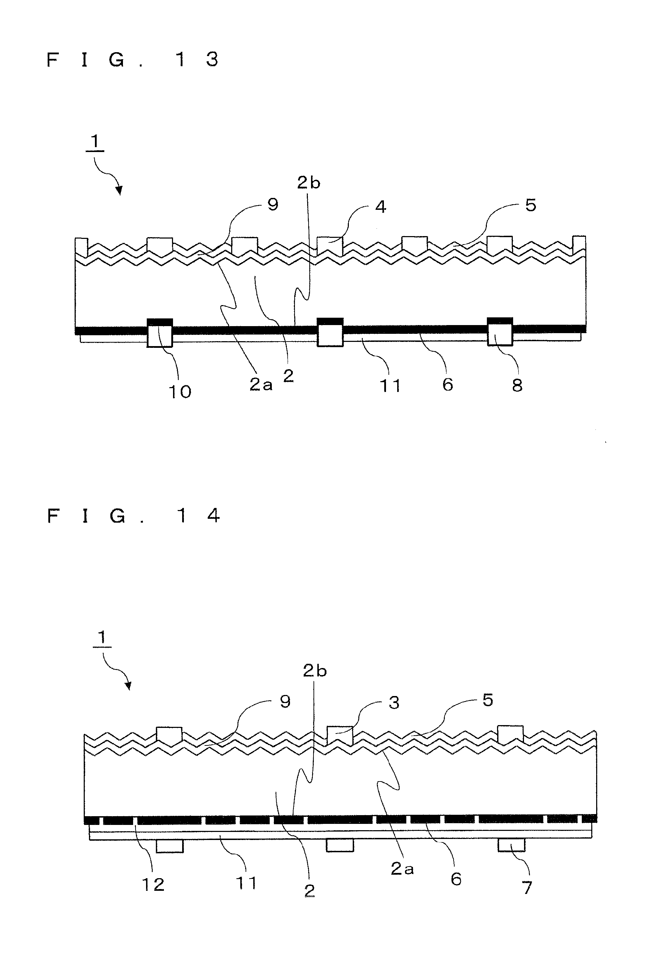

As shown in FIG. 10(a), the passivation film 6 is removed in the substantially entire region of the back surface side finger electrodes 8, to provide connection portions (denoted by the reference numeral 12 of FIG. 14 which will be described later) for connection between the back surface side finger electrodes 8 and the semiconductor substrate. On the other hand, as shown in FIG. 10(b), the passivation film 6 is removed in parts of the back surface side finger electrode 8, to provide connection portions in a point-like shape for connection between the back surface side finger electrodes 8 and the semiconductor substrate. This can reduce the amount of recombination current that is proportional to the area of contact between a metal and a semiconductor, and therefore can improve output characteristics of the photoelectric conversion element 1. At this time, the connection portions in the point-like shape are formed at intervals of 200μm or more and 1mm or less. In terms of carrier collection, it is preferable that connection portions for connection with the semiconductor substrate are also provided on the back surface side bus-bar electrode 7. As a method for removing the passivation film 6, a region other than a region to be removed is covered with a mask, and then removed by a wet etching process or a dry etching process. The use of laser enables the removal to be easily performed at a high speed without increasing the number of steps.

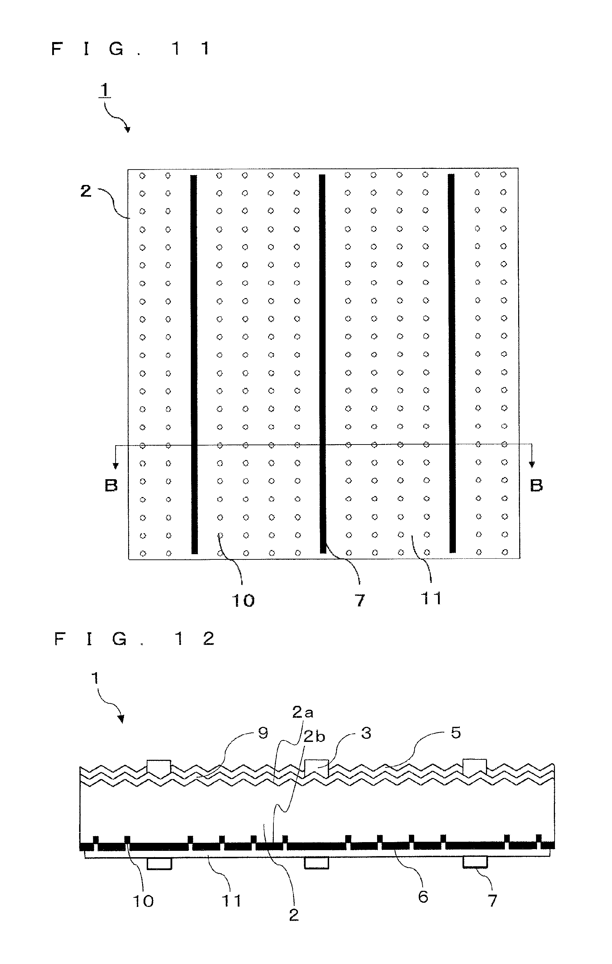

Alternatively, it may be possible that, as shown in FIGS. 11 and 12, the above-mentioned back surface side finger electrodes 8 are not formed and a transparent conductive film 11 connected to the back surface side bus-bar electrodes 7 is provided substantially over the entire region of the back surface. Such a structure allows the light reflected by the reflecting member to be transmitted therethrough better. As the transparent conductive film 11, an oxide-type transparent conductive film of $SnO_2$, ITO, ZnO, or the like, may be adopted. As a method for forming this film, a sputtering process, a thermal CVD process, a LPCVD (Low Pressure Chemical Vapor Deposition) process, or the like, can be adopted.

Moreover, as shown in FIG. 13, the transparent conductive film 11 may be provided between the back surface side finger electrodes 8. This can reduce resistive losses even with increased intervals of the back surface side finger electrodes 8.

Furthermore, a BSF layer 10 configured as a semiconductor layer having the first conductivity type at a high concentration may be formed in a connection portion between the semiconductor substrate 2 and the back surface side bus-bar electrodes 7, the back surface side finger electrodes 8, or the transparent conductive film 11. This reduces the recombination of carriers in a contact region where the semiconductor substrate 2 is in contact with the back surface side finger electrodes 8 (a so-called back surface field effect is exhibited), which can improve the characteristics. As a method for forming the BSF layer 10 mentioned above, there can be adopted, for example, a method of forming it at a temperature of about 800°C or more 1100°C or less by a thermal diffusion process that uses boron tribromide ($BBr_3$) as a diffusion source, or a method of applying an Al paste by a printing process and then subjected to a heat treatment (baking) at a temperature of about 600°C or more 850°C or less to thereby diffuse Al in the semiconductor substrate 1. If a fire-through process is adopted in which an Al paste is directly formed in a predetermined region on the passivation film 6 and subjected to a heat treatment at a high temperature, the BSF (Back-Surface-Field) layer 10 can be formed without preliminarily removing the passivation film 6. Alternatively, an Al layer is formed on the passivation film 6 by a sputtering process, a vapor deposition process, or the like, and this Al layer is locally irradiated with a laser light and thus melted. Thereby, an Al component penetrates through the passivation film 6 and is brought into contact with and reflected at the silicon substrate, thus forming a BSF region (using a laser fired (melted) contact process (LFC process)).

The method for forming the BSF layer 10 is not limited to the above-described ones. For example, a thin film technique may be used to form a thin film layer such as a hydrogenated amorphous silicon film or a crystalline silicon film including a microcrystalline silicon film having the first conductivity type at a high concentration. Furthermore, an i-type silicon region may be formed between the semiconductor substrate 2 and the BSF layer 10.

For example, it may be possible that, as shown in FIG. 14, after the passivation film 6 is formed on the back surface of the semiconductor substrate 2, for the formation of the connection portion 12 for connection with the semiconductor substrate 2, the passivation film 6 is removed in a point-like shape at intervals of, for example, 200μm or more and 1mm or less by using a sandblasting process or a mechanical scribing process, and further a laser process and the like, and then a thin film layer 12 (a hydrogenated amorphous silicon film or a microcrystalline silicon film) having the first conductivity type at a high concentration is formed with a thickness of about 5nm or more and 50nm or less and with a dopant concentration of about $1 \times 10^{18}$ atoms/cm$^3$ or more and $1 \times 10^{21}$ atoms/cm$^3$ or less, on which the transparent conductive film 11 and the back surface side bus-bar electrode 7 are then formed. For the formation of the thin film layer 12, a CVD process, a plasma CVD (PECVD) process, a Cat-CVD process, or the like, is suitably used. Particularly, the use of the Cat-PECVD process enables the formation of the thin film layer 12 with a very high quality, and thus the quality of a hetero junction formed between the semiconductor substrate 2 and the thin film layer 12 is improved. In a case of forming a silicon thin film layer, in addition to silane and hydrogen, diborane for adding B (boron) as the dopant in a case of the p-type or phosphine for adding P (phosphorus) as the dopant in a case of the n-type may be used as a raw gas.

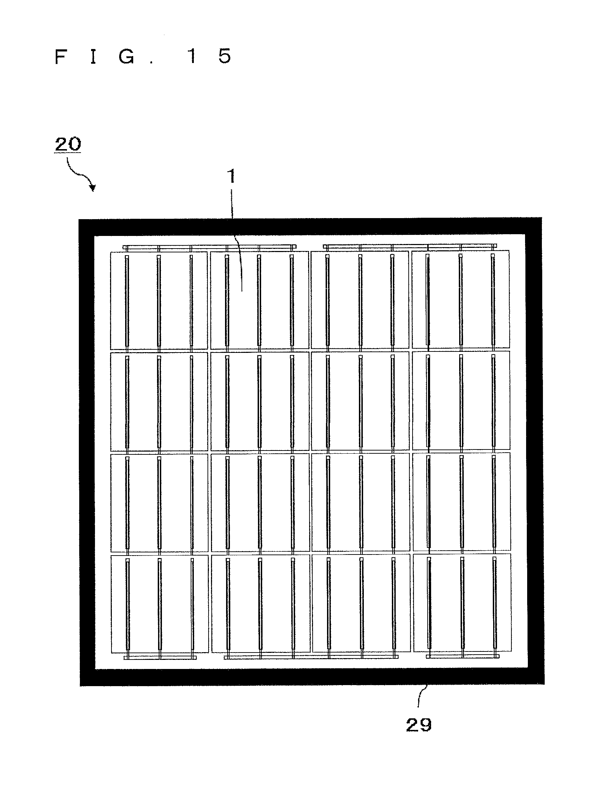

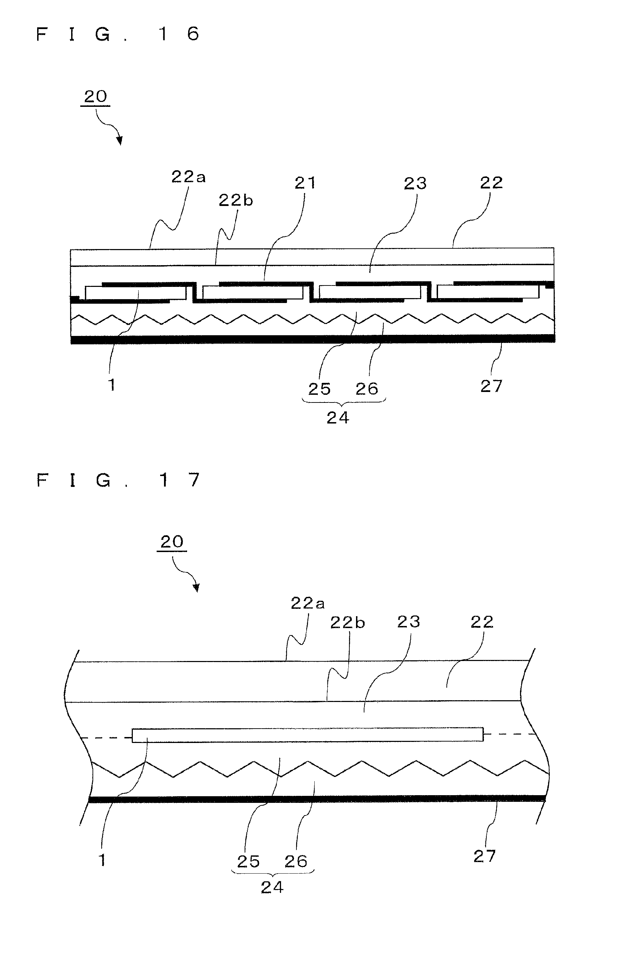

As shown in FIGS. 15 and 16, in a photoelectric conversion module 20 according to this embodiment, for example, a plurality of photoelectric conversion elements 1 that are electrically connected to one another by ribbon-shaped connection wirings 21 made of a metal are provided between a back surface member 27 and a light-transmitting substrate 22 including a first surface 22a and a second surface 22b. The plurality of photoelectric conversion elements 1 are sealed with the light-receiving surface side sealing member 23 and the back surface side sealing member 24, and thus constitutes a photoelectric conversion panel. A frame body 29 is attached to an outer peripheral portion of the photoelectric conversion panel, and additionally, a terminal box (not shown) to which a cable for connecting generated electric power to an external circuit is connected is provided on the back surface thereof.

Hereinafter, a specific description will be given to each of component parts of the photoelectric conversion panel shown in FIG. 16.

As the light-transmitting substrate 22, a substrate made of, for example, glass or a polycarbonate resin and including the first surface 22a on which a light is incident and the second surface 22b located at the opposite side thereof is adopted. As for the glass, white glass, tempered glass, double-tempered glass, heat-reflective glass, or the like, is adopted. For example, white tempered glass having a thickness of about 3mm or more 5mm or less is adopted. In a case where a substrate is made of a synthetic resin such as a polycarbonate resin, the one having a thickness of about 5mm is used.

Each of the light-receiving surface side sealing member 23 and the back surface side sealing member 24 is made of EVA (refractive index n is about 1.52) being shaped into a sheet shape having a thickness of about 0.4mm or more 1mm or less. Heat and pressure are applied to them under reduced pressure by means of a laminating apparatus, and thereby they are soften and fused and thus integrated with another member.

For the back surface member 27, a weatherproof fluorine-contained-resin sheet in which an aluminum foil is sandwiched in order to prevent moisture permeance, or a polyethylene terephthalate (PET) sheet having alumina or silica vapor-deposited thereon, or the like, is used.

Here, in the photoelectric conversion module according to the present invention, as shown in FIG. 17, the back surface side sealing member 24 comprises a transparent light-transmitting member 25 having insulation properties and a reflecting member 26 colored with white by titanium oxide, a pigment, or the like, contained therein. An interface between the light-transmitting member 25 and the reflecting member 26 has a concavo-convex structure in which a plurality of inclined slopes intersect one another. The interface functions as a light reflection interface. Here, the angle θ formed between the above-mentioned inclined light reflection surface and a place parallel to the light-receiving surface is adjusted in accordance with the refractive index n of the light-transmitting member 25, based on the TIRAFS occurrence principle described above. For example, when the refractive index is about 1.5, the angle may be set to be 20° or more and 35° or less. Although it is more preferable that the above-mentioned inclined light reflection surface is formed as a flat surface, even a concavo-convex structure having concave curved surfaces which will be described later can also significantly exert the TIRAFS effect. The average concavo-convex pitch is set to be about 3μm or more.

In the above-described structure, among the lights incident on the light-receiving surface of the module, a light passing between the photoelectric conversion element 1 and the photoelectric conversion element 1 can be reflected at the reflection interface and then totally reflected at the light-receiving surface (first surface 22a) of the light-transmitting substrate 22. This considerably improves the light confinement performance.

The light-transmitting member 25 and the reflecting member 26 provided with such inclined slopes can be made by transferring something, such as a metal mold, having a predetermined concavo-convex structure that satisfies the above-described angle condition during the making of an EVA sheet. That is, in making the EVA sheet, immediately after a thin-plate-like EVA is manufactured by a melt extrusion process, it is pinched between a shaping roller having a predetermined concavo-convex structure and a pressure roller and pressed. Thus, a predetermined concavo-convex shape can be formed in a surface of the thin-plate-like EVA.

The light-transmitting substrate 22, the light-receiving surface side sealing member 23, the photoelectric conversion element 1, the back surface side sealing member 24 (including the light-transmitting member 25 and the reflecting member 26), and the back surface member 27 are stacked, and in this state, a laminator applies heat and pressure thereto under reduced pressure, so that they are integrated to make the photoelectric conversion panel. The frame body 29 made of aluminum or the like is fitted to the outer peripheral portion of the photoelectric conversion panel, and fixed by corner portions thereof being screwed. Additionally, the terminal box is fixed to the back surface side of the photoelectric conversion panel with an adhesive. Thus, the photoelectric conversion module is completed.

For the light-transmitting member 25 or the reflecting member 26 that constitutes the sealing member having the light reflection interface, a resin plate made of acrylic (refractive index n is about 1.49), polycarbonate (refractive index is about 1.59), or the like, may be used. For example, it may be acceptable that a transparent EVA is used for the light-transmitting member 25 while, at the back surface side thereof, a white resin plate provided with concavity and convexity having the predetermined shape mentioned above is used as the reflecting member 26. In this case, it is not necessary to form the concavity and convexity in the transparent EVA serving as the light-transmitting member 25, and moreover the resin plate serving as the reflecting member 26 can be also used as the back surface member. Thus, the photoelectric conversion module can be easily made.

Such a structure is also acceptable that a transparent resin plate provided with concavity and convexity having the predetermined shape mentioned above is arranged at the back surface side of the photoelectric conversion element such that a concavo-convex surface thereof faces the back surface side of the photoelectric conversion module, and moreover a white EVA is arranged at the back surface side thereof, and furthermore the back surface member is arranged at the back surface side thereof. Here, for bonding the element and the resin plate to each other, the transparent EVA may be used, or other transparent adhesive materials may be used. It may be also possible that the white EVA is omitted and a white back surface member is bonded to the resin plate.

Hereinafter, a description will be given to the photoelectric conversion module 20 that adopts a resin plate as at least either one of the light-transmitting member 25 and the reflecting member 26.

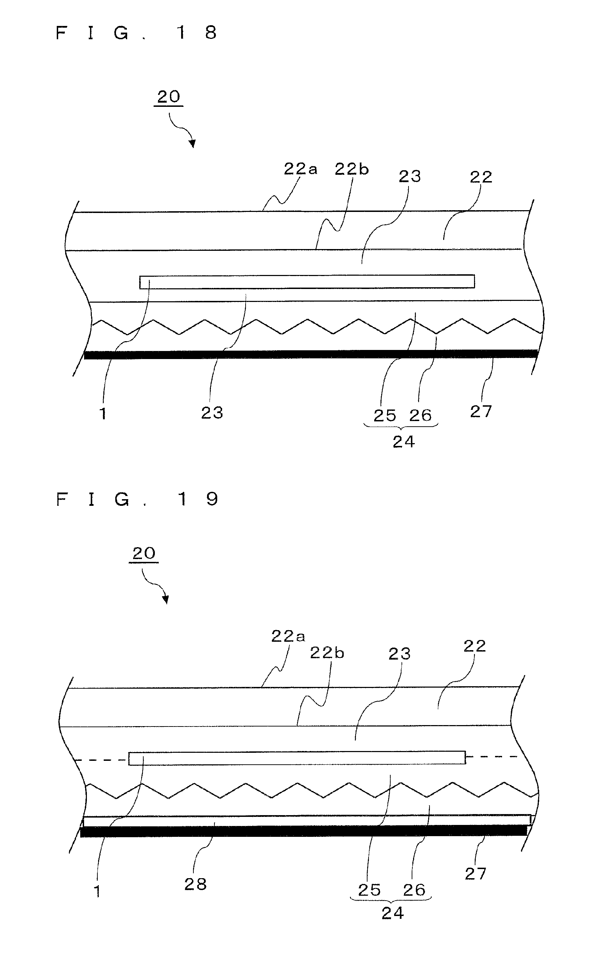

In the photoelectric conversion module 20 shown in FIG. 18, a light-transmitting resin plate made of, for example, transparent acrylic provided with concavity and convexity having the predetermined shape mentioned above is used as the light-transmitting member 25. Additionally, at the back surface side thereof, a white EVA serving as the reflecting member 26 is arranged, and moreover at the back surface side thereof, the back surface member 27 is arranged. In this structure, an interface between the resin-made light-transmitting member 25 and the white EVA arranged at the back surface side thereof and serving as the reflecting member 26 comprises inclined slopes having a predetermined angle. In this photoelectric conversion module 20, the transparent EVA at the back surface side can be omitted, and therefore the photoelectric conversion module can be more simply made at a lower cost.

In the photoelectric conversion module 20 shown in FIG. 19, a transparent EVA serving as the light-transmitting member 25 is arranged at the back surface side of the photoelectric conversion element 1, and at the back surface side thereof, a white resin plate provided with concavity and convexity having the predetermined shape is used as the reflecting member 26. Moreover, at the back surface side thereof, a white EVA 28 is arranged, which however may be omitted in some cases. Furthermore, at the back surface side thereof, the back surface member 27 is arranged. In this structure, an interface between the transparent EVA arranged at the back surface side and serving as the light-transmitting member 25 of the photoelectric conversion element 1 and the white resin plate serving as the reflecting member 26 comprises inclined slopes having the predetermined angle. In this photoelectric conversion module 20, the consumption of the white EVA arranged at the back surface side can be reduced, and therefore the photoelectric conversion module can be more simply made at a lower cost.

The resin plate serving as the reflecting member 26 may also be used as the back surface member. Such a structure enables the white EVA 28 and the back surface member 27 at the back surface side to be omitted, and therefore the photoelectric conversion module can be simply made at a low cost.

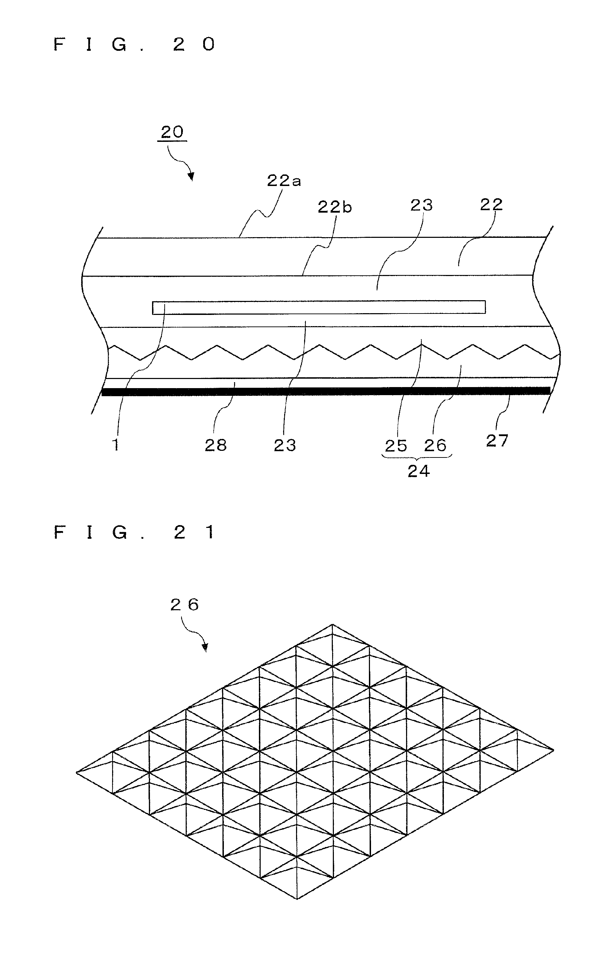

In the photoelectric conversion module 20 shown in FIG. 20, a transparent EVA (which, in the drawing, is the same as the EVA 23) serving as a part of the light-transmitting member 25 is arranged at the back surface side of the photoelectric conversion element 1, and additionally, at the back surface side thereof, a transparent resin plate provided with concavity and convexity having the predetermined shape that also serves as a part of the light-transmitting member 25 is used, and moreover, at the back surface side thereof, a white resin having a concavo-convex shape that is fittable with the concavity and convexity is used as the reflecting member 26. Furthermore, at the back surface side thereof, the white EVA 28 is arranged, which however may be omitted in some cases. Furthermore, at the back surface side thereof, the back surface member 27 is arranged. This photoelectric conversion module 20 makes the EVA thickness uniform in a plane, and therefore a photoelectric conversion module having a more excellent moisture resistance can be made.

For the reflecting member 26, a plate body in which a large number of pyramid shapes are orderly arranged in four directions may be used as shown in FIG. 21, and alternatively a plate body having a so-called V-groove structure in which a large number of triangular prisms are arranged in a constant direction may be used as shown in FIG. 22. The use of such a reflecting member 26 enables the light to be efficiently reflected, and thus the efficiency of the photoelectric conversion module can be increased.

In a case where a light-transmitting member 13a and a reflecting member 13b are made by a resin plate such as a transparent or white acrylic plate, an acrylic resin liquefied by a solvent or the like is poured into, for example, a metal or glass mold having the predetermined concavo-convex structure, and thereby a resin plate to which the concavo-convex shape of the mold mentioned above has been transferred can be made. Here, for curing the resin, a thermal-curing process, a photo-curing process, or the like, is adoptable.

It may be also possible that a silicone resin or the like is used for the light-transmitting member and printed on the back surface side of the element, and a mold having the predetermined concavo-convex structure is pressure-bonded against the top of a printed surface, thereby making a desired concavo-convex structure on the printed surface.

As a method for making a mold for the formation of the predetermined concavo-convex structure, there is a method of making it by process a metal or the like as mentioned above. As a notably simple making method, the following method can be mentioned.

That is, by using a RIE (reactive ion etching) apparatus, a flat-plate glass is processed with a fluorine-based gas, a chlorine-based gas, an oxygen gas, or the like, for about 6 minutes under the condition of a high-frequency output of $1 \ W/cm^2$ or more and $3 \ W/cm^2$ or less and about 4 Pa. Additionally, a resultant is processed with an aqueous solution of about 0.1% or more and 3% or less of hydrofluoric acid (HF) at ambient temperature about 5 minutes or more and 120 minutes or less. As a result, a mold provided with a concavo-convex structure (dimple structure) having concave curved surfaces can be made. FIG. 23 is a schematic diagram showing the concavo-convex structure formed in this manner. FIG. 24 shows a microscope photograph of a specific example. FIG. 24(a) corresponds to a case where the process with the aqueous solution of HF is performed for a short time of 5 minutes or more and 30 minutes or less. FIG. 24(b) corresponds to a case where such a process is performed for a long time of 30 minutes or more and 120 minutes or less.

As a method for obtaining the similar concavo-convex structure having curved surfaces, a method can be mentioned in which a flat-plate glass is subjected to a sandblasting process so that a surface is roughened by using a blasting material such as a particulate alumina ($Al_2O_3$) (for example, an alumina abrasive having an average particle diameter of about $12\mu$m or more and $17\mu$m or less), and additionally a resultant is processed with an aqueous solution of about 0.1% or more and 3% or less of hydrofluoric acid (HF) at ambient temperature for about 5 minutes or more and 60 minutes or less.

Thus, a glass surface is roughened by a RIE process or a sandblasting process, and then processed with an aqueous solution of hydrofluoric acid. A concavo-convex structure having concave curved surfaces obtained in this manner is, as shown in the photograph of FIG. 24, a gentle concavo-convex structure having a suitable angle range (with the maximum angle of about 35°, and the average pitch P / radius of curvature r = about 1.2) and a suitable average pitch (about $3\mu$m) for achieving the TIRAFS. Accordingly, the photoelectric conversion module having the concavo-convex structure mentioned above formed by using this as a mold can achieve a high energy conversion efficiency.

Next, a more specific example of the embodiment 1 will be described.

<Example 1>

Firstly, a semiconductor substrate made of polycrystalline silicon made by a casting process was prepared. This semiconductor substrate contained about $1 \times 10^{16}$ atoms/cm$^3$ or more and $10^{18}$ atoms/cm$^3$ or less of boron (B) as a p-type impurity, and had a specific resistance of about 0.2 $\Omega\cdot$cm or more and 2.0 $\Omega\cdot$cm or less. The size thereof was about 150mm squares, and the thickness thereof was about 0.2mm.

For cleaning a surface of this semiconductor substrate, the surface was etched by an extremely small amount by an aqueous solution of about 20% of sodium hydroxide, and then cleaned.

Then, by using a RIE (reactive ion etching) apparatus, a concavo-convex (roughened) structure having a light-reflectance reduction function was formed at the light-receiving surface side of the semiconductor substrate serving as a light incident surface.

Then, an n-type semiconductor layer was formed on the entire surface of the semiconductor substrate. Preferably, P (phosphorus) is used as a doping element for the exhibition of n-type, and the n-type layer with a sheet resistance of about 30$\Omega$/□ or more and 300$\Omega$/□ or less was made. As a result, a pn junction portion for junction with the p-type bulk region mentioned above was formed.

The n-type semiconductor layer was formed in the following manner. The temperature of the semiconductor substrate was raised to and kept at about 700°C or more and 900°C or less, and in this state, a vapor phase thermal diffusion process was performed for about 20 minutes or more and 40 minutes or less, which is a process under an atmosphere of phosphorus oxychloride ($POCl_3$), a gas serving as a diffusion source. Thereby, the n-type semiconductor layer was formed in a depth of about $0.2\mu$m or more and $0.7\mu$m or less. In such a case, since phosphorus glass was formed on the entire surface of the semiconductor substrate, for removing this phosphorus glass, the semiconductor substrate was immersed in hydrofluoric acid, and then cleaned and dried.

Subsequently, for pn junction isolation, an outer peripheral portion of the semiconductor substrate at the back surface side thereof was irradiated with a laser beam, to form an isolation trench to at least such a depth as to reach the pn junction portion. This laser apparatus was a YAG (yttrium, aluminum, garnet) laser apparatus.

Then, the n-type semiconductor layer provided at the back surface side was removed. For the removal, for example, a wet etching process using a mixed acid (a mixed liquid of hydrofluoric acid and nitric acid) or a dry etching process using an etching gas of $SF_6$, $NF_3$, $ClF_3$, or the like, can be adopted. In this etching to the back surface side, an application of a resist (in a case of the wet etching, a resist having an acid resistance) or the like to the surface side can prevent damage to the surface side.

The removal of this n-type semiconductor layer provided at the back surface side may be performed after the formation of a SiNx film serving as an anti-reflection film which will be described later, by using an alkaline solution of KOH or the like. In such a case, at the surface side, the SiNx film serving as the anti-reflection film functions as an etching prevention film.

Then, a p+ layer was locally formed at the back surface side. More specifically, by a screen printing process, a paste containing aluminum as a main component was applied in a shape corresponding to a pattern of the back surface side electrodes that would be formed later, and then baked. This paste used for the p+ layer was made of powdered aluminum, an organic vehicle, and the like. After this was applied, a resultant was heat-treated (baked) at a temperature of about 700°C or more and 850°C or less, so that aluminum was burned into a silicon wafer. Then, a resultant was immersed in an aqueous solution of about 15% of hydrochloric acid at 80°C for about 10 minutes, to remove unnecessary aluminum, thus exposing the p+ layer. Because of the formation of this p+ layer, the photoelectric conversion efficiency of the photoelectric conversion element could be improved due to the BSF effect, and additionally its contact property with an electrode that is made of silver and would be formed at the back surface as will be described later could also be improved.

It is desirable to, as need arises, clean a surface of the back surface where the p+ layer was exposed. That is, immersion in a diluted hydrofluoric acid liquid is applicable, or alternatively the so-called RCA cleaning (a clearing process for a semiconductor substrate developed by the RCA company in the USA, that uses a concentrated chemical liquid containing hydrogen peroxide as a base thereof with an alkali or an acid being added thereto), or an equivalent clearing process (such as the SPM (Sulfuric acid-Hydrogen Peroxide Mixture) cleaning), is applicable. In this case, for the protection of the surface side, for example, a method using the resist mentioned above or a method using, as a protection film, the SiNx film that is the anti-reflection film which will be described later (a method in which the cleaning is performed after the formation of the anti-reflection film 5) can be adopted. Then, an anti-reflection film and a passivation film were formed.

On the light-receiving surface side surface, a silicon nitride (SiNx) film serving as an anti-reflection film was formed at a temperature of about 450°C using a monosilane gas or an ammonia gas, by a PECVD apparatus. The refractive index of this silicon nitride (SiNx) film was set to be about 2.0 and a film thickness thereof was set to be about 80nm, for exhibiting an anti-reflection effect.

On the back surface side, a silicon nitride (SiNx) film serving as a passivation film was formed at a temperature of about 350°C using a monosilane gas or an ammonia gas, by a PECVD apparatus. The film thickness of this silicon nitride (SiNx) film was set to be about 10nm or more and 200nm or less.

Before the passivation film is formed, a predetermined pre-process may be applied to the surface of the semiconductor substrate as the surface to which the film will be formed. To be specific, a hydrogen plasma process, a hydrogen/nitrogen mixed gas plasma process, or the like, may be applied. By the process with such a gas, a passivation performance can be improved.

Then, a conductive paste was directly applied in a predetermined pattern onto the anti-reflection film by using a screen printing process, and then baked. Thereby, the light-receiving surface side bus-bar electrodes and the light-receiving surface side finger electrodes were formed. At this time, due to fire-through, the electrodes at the surface side and the n-type semiconductor layer were brought into electrical contact with each other. The conductive paste used for this was obtained by adding, to 100 parts by weight of powdered silver, 5 parts by mass or more and 30 parts by mass or less of an organic vehicle and 0.1 parts by mass or more and 10 parts by mass or less of a glass frit. After the conductive paste was applied and dried, the baking was performed in a baking furnace for about several seconds up to a maximum temperature of 700°C or more and 850°C or less (RTA (Rapid Thermal Annealing) process). After such baking was performed, the thickness of the light-receiving surface side bus-bar electrodes and the light-receiving surface side finger electrodes was about 10μm or more and 20μm or less.

Then, a conductive paste was directly applied in a predetermined pattern (a pattern corresponding to the above-mentioned part where the p+ layer was exposed) onto the passivation film at the back surface side, and then baked. As a result, the back surface side bus-bar electrodes and the back surface side finger electrodes were formed. At this time, due to fire-through, the electrodes at the back side and the p+ layer mentioned above were brought into electrical contact with each other.

The baking of the light-receiving surface side electrodes and the baking of the back surface side electrodes described above may be concurrently performed.

After the formation of the light-receiving surface side electrodes and the back surface side electrodes described above, an annealing process may be performed. To be specific, a so-called FGA process (a forming-gas annealing process using a mixed gas of hydrogen and nitrogen) can be performed at about 400°C for about several minutes or more and 10 minutes or less. This can improve the passivation performance of the passivation film 6.

The photoelectric conversion module was made as follows. Firstly, a ribbon-shaped connection wiring having a width of about 2mm and a length of about 250mm was soldered to each of the light-receiving surface side bus-bar electrodes and the back surface side bus-bar electrodes of the photoelectric conversion element described above. This ribbon-shaped connection wiring was obtained by coating the entire surface of a copper foil with an eutectic solder.

As the light-transmitting substrate, a white tempered glass having a thickness of about 5mm and a size of about 180mm squares was used. Thereon, a transparent EVA sheet having a thickness of about 0.4mm and serving as the light-receiving surface side sealing member was arranged. Thereon, the photoelectric conversion element was placed, and thereon a transparent EVA sheet having a thickness of about 0.4mm and serving as the light-transmitting member was placed. Thereon, a white acrylic plate having a thickness of about 5mm and serving as the reflecting member, in which a light reflection surface thereof was provided with a concavo-convex structure having a predetermined shape, was placed such that the concavo-convex surface was in contact with the transparent EVA sheet. The predetermined concavo-convex structure mentioned above was set such that slopes thereof were flat, the angle of the slopes was in a range of 20° or more and 35° or less with an average of 30°, and an average concavo-convex pitch was 1mm.

A stack of them was set in a laminator apparatus and, while being heated to 120°C or more and 150°C or less under reduced pressure of about 100Pa, pressed for 15 minutes, to integrate the stack. This integrated stack was held in a crosslinking oven at about 150°C under atmospheric pressure for about 60 minutes, to promote a crosslinking reaction of EVA. Thus, the photoelectric conversion module according to this example was completed.

Moreover, as a comparative photoelectric conversion module that was to be compared with this photoelectric conversion module, a photoelectric conversion module in which an interface between a light-transmitting member and a reflecting member was a flat interface having no concavo-convex structure was made.

The two photoelectric conversion modules made in this manner were measured for their output characteristics, at an element temperature of 25°C and with artificial sunlight of AM1.5 and 100mW/cm$^2$. Results thereof are shown in Table 2. In the Table, Jsc and Voc indicate the characteristics per one cell.

[Table 2]

| | Concavity and Convexity of Back Surface | Jsc [mA/cm$^2$] (Up Rate) | Voc [V] | FF | Efficiency [%] (Up Rate) |
|---|---|---|---|---|---|
| Comparative Example | None | 35.71 | 0.613 | 0.730 | 15.98 |
| Example | Flat Slope θ: 20° to 35° Pitch: 1mm | 36.77 (3%) | 0.613 | 0.730 | 16.45 (3%) |

As shown in Table 2, in the photoelectric conversion module according to this example, the Jsc was improved by 3% and the photoelectric conversion efficiency was also improved by 3% as compared with the conventional one. Thus, an effect thereof was observed.

<Embodiment 2>

Next, a description will be given to an example of an embodiment of the thin-film type photoelectric conversion element in which the photoelectric conversion element of the photoelectric conversion module is made of an a-Si film, a μc-Si film, or a combination thereof.

In the following description, a tandem type (a-Si/μc-Si type) photoelectric conversion element that is a photoelectric conversion element in which a p-i-n junction cell (hereinafter, an a-Si unit cell) whose i layer is formed of an a-Si film and a p-i-n junction cell (hereinafter, a μc-Si unit cell) whose i layer is formed of a μc-Si film are stacked is adopted as a typical structure of the thin-film type photoelectric conversion element. However, this embodiment is not limited thereto. That is, a simple p-i-n junction cell adopting only the a-Si unit cell may be acceptable, or alternatively a multi-junction type tandem element such as a three-tandem type (triple junction type) may be acceptable in which the a-Si unit cell and the μc-Si unit cell mentioned above are further combined. Moreover, an element can also be used in which a photoelectric conversion element that adopts a compound semiconductor such as a chalcopyrite-type solar cell typified by CIS (copper indium selenide)-type one is prepared in the super straight type.

As shown in FIG. 25, a photoelectric conversion module 30 comprises the light-transmitting substrate 22 having the first surface 22a on which a light is incident and the second surface 22b located at the opposite side of the first surface 22a. On the second surface 22b, a light-receiving surface side light-transmitting electrode 31, photoelectric conversion layers 32 and 34, and a back surface side light-transmitting electrode 35 are stacked.

In a case where a silicon-type thin film is used as the material of the photoelectric conversion layers 32 and 34, it is preferable that the glass used for the light-transmitting substrate 22 is white glass and, desirably, white tempered glass that is manufactured by melting a material having a low iron content, which enables a wavelength of 350nm or more to be efficiently transmitted therethrough and moreover having a high transmittance up to a long wavelength region near 1200 nm that is the upper limit of a light wavelength contributable to power generation.

As for a transparent conductive material for the light-receiving surface side light-transmitting electrode 31, an oxide-type transparent conductive film may be made of, for example, fluorine doped tin oxide ($SnO_2$:F), indium tin oxide (ITO), aluminum doped zinc oxide (ZnO:Al), or boron doped zinc oxide (ZnO:B). As a film formation method for such a light-receiving surface side light-transmitting electrode 31, a method of a sputtering process, a thermal CVD process, a LPCVD process, or the like, is preferably adopted. Desirably, the film thickness is set to be about 500 nm or more and 2000 nm or less. Desirably, a surface of the oxide-type transparent conductive film thus formed is given a concavo-convex shape so that an optical path length can be increased in order to improve the amount of light absorption in the photoelectric conversion element. In the thermal CVD process, a suitable concavo-convex shape can be provided by appropriately selecting a condition during the film formation. On the other hand, in the sputtering process and the LPCVD process, it is desirable to form a concavo-convex shape by an etching process if need arises after the film formation. In a preferable concavo-convex shape, an average pitch (the average value of intervals of apexes, or the average value of intervals of valleys) based on measurements at five or more points is about 0.1 μm or more and several μm or less, and the average height (the average value of intervals between the apexes and the bottoms of the valleys) is about

0.05μm or more and 1μm or less.

Additionally, on the light-receiving surface side light-transmitting electrode 31, the photoelectric conversion layers 32 and 34 are formed. In this embodiment, silicon-type thin films are formed in the photoelectric conversion layers 32 and 34. Their structure is defined as a two-tandem structure element made of a-Si/μc-Si where the a-Si unit cell 32 and the μc-Si unit cell 34 are stacked in this order from the light-receiving surface side light-transmitting electrode side. This can widen a light wavelength band region that can be absorbed by the photoelectric conversion layer, and therefore can improve the power generation efficiency. The thickness of the photoelectric conversion layers 32 and 34 may be, in a case of the a-Si unit cell 32, 0.1μm or more and 0.5μm or less and preferably 0.15μm or more and 0.3μm or less, and in a case of the μc-Si unit cell 34, may be 1μm or more and 4μm or less and preferably 1.5μm or more and 3μm or less. The above-mentioned photoelectric conversion layers 32 and 34 can be formed by a method such as a plasma CVD process.

Furthermore, on the photoelectric conversion layers 32 and 34, the back surface side light-transmitting electrode 35 made of a transparent conductive material is formed. In a case of forming this back surface side light-transmitting electrode, a sputtering process or a LPCVD process is preferably used because such processes can form a film at a low substrate temperature of 250°C or less in order to cause no quality loss of the photoelectric conversion layers 32 and 34 that have been already formed. As for the transparent conductive material of the back surface side light-transmitting electrode 35, similarly to the light-receiving surface side light-transmitting electrode, an oxide-type transparent conductive film may be made of, for example, $SnO_2$:F, ITO, ZnO:Al(AZO), or ZnO:B(BZO). Among them, particularly, ZnO is more preferable because it has an excellent transmittance with respect to a long wavelength light.

The photoelectric conversion element described above may have a so-called integrated type structure, which is the structure that is widely employed for making a photoelectric conversion module (not shown). This integrated type structure can be easily formed by performing a patterning process (laser-scribing process) using a laser on each of the light-receiving surface side light-transmitting electrode 31, the photoelectric conversion layers 32 and 34, and the back surface side light-transmitting electrode 35.

More specifically, after the formation of the light-receiving surface side light-transmitting electrode 31, a scribing called P1 is performed to thereby cause an electrical isolation in the light-receiving surface side light-transmitting electrode 31 in a predetermined pattern. Then, after the formation of the photoelectric conversion layers 32 and 34, a scribing called P2 is performed to thereby form, in the photoelectric conversion layers, a groove (which will serve as a contact region where the back surface side light-transmitting electrode 35 formed in a subsequent step is in contact with the light-receiving surface side light-transmitting electrode 31) in which the light-receiving surface side light-transmitting electrode 31 is exposed. After the formation of the back surface side light-transmitting electrode 35, a scribing called P3 is performed to thereby cause an electrical isolation in the back surface side light-transmitting electrode 35 in a predetermined pattern. Through the above, a so-called integrated type structure is achieved.

The photoelectric conversion module of this embodiment is structured such that the sealing member including the light-transmitting member 25 and the reflecting member 26, and the back surface member 27 are arranged on the back surface side of the back surface side light-transmitting electrode 35 of the photoelectric conversion element. The interface (reflection interface) between the light-transmitting member 25 and the reflecting member 26 has a predetermined concavo-convex structure (slopes that form the concavo-convex structure). Here, the angle θ formed between the inclined light reflection surface and a plane parallel to the light-receiving surface mentioned above is adjusted in accordance with the refractive index n of the light-transmitting member based on the above-described occurrence principle of the present invention. For example, when the refractive index is about 1.5, the angle may be set to be 20° or more and 35° or less. Although it is more preferable that the inclined light reflection surface is a flat surface, even a concavo-convex structure with concave curved surfaces as shown in the embodiment 1 can also exert the effects of the present invention to a significant level. The average concavo-convex pitch is set to be about 3μm or more.

As a resin material for the light-transmitting member 25, EVA or polyvinyl alcohol resin (PVA) is adoptable, and EVA is preferably adoptable because its reliability such as water resistance is excellent.

The reflecting member 26 may be any member as long as it is in contact with light-transmitting member 25 and reflects a light. For example, EVA colored with white by titanium oxide, a pigment, or the like, contained therein, or a white resin such as a fluorine contained resin or an acrylic resin, can be used.

Here, the same material and the same methods as those described in the embodiment 1 can be used as a selection of a material, a combination method, and a method for forming the concavo-convex structure of the interface, as for the light-transmitting member 25 and the reflecting member 26 provided with the inclined light reflection surface so that the above-described reflection interface has a predetermined concavo-convex structure.

For the back surface member 27, a weatherproof fluorine-type-resin sheet in which an aluminum foil is sandwiched in order to prevent moisture permeance, or a polyethylene terephthalate (PET) sheet having alumina or silica vapor-deposited thereon, or the like, is used.

The photoelectric conversion module 30 is made by stacking the light-transmitting member 25, the reflecting member 26, and the back surface member 27 on the back surface side light-transmitting electrode 35 of the photoelectric conversion element and then applying heat and pressure under reduced pressure by means of a laminating apparatus to thereby integrate these members.

The structure of the photoelectric conversion module is not limited to the above-described one. Instead of a fluorine resin sheet as the back surface member 27, a glass plate may be used. That is, a laminated glass type structure may be used.

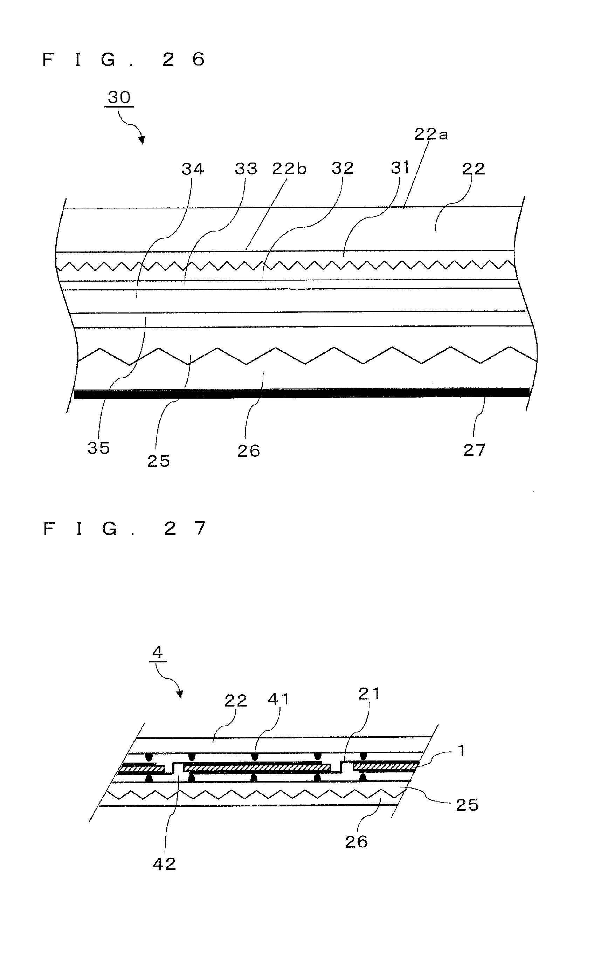

As in the photoelectric conversion module 30 shown in FIG. 26, a light-transmitting intermediate layer 33 may be provided between the a-Si unit cell 32 and the µc-Si unit cell 34. It is desirable that the refractive index of this intermediate layer is 2.5 or less and more preferably 2.0 or less in the vicinity of a wavelength of 600nm. As for a material of the intermediate layer 33, for example, not only an oxide-type transparent conductive film made of $SnO_2$, ITO, or ZnO, but also a Si-based compound film made of SiO, SiC, or SiN may be used. In a case of the Si-based compound film, it is desirable to use a microcrystalline Si-based compound containing microcrystalline Si, in terms of increasing the conductivity (reducing a loss due to the resistance). Additionally, the conductivity can be further increased by doping boron (B) or phosphorus (P).

Providing such an intermediate layer 33 can improve a photocurrent of the photoelectric conversion element 30. There are two reasons therefor.

Firstly, with respect to an incident light in a wavelength range near and less than 600nm (a light in a relatively short wavelength region), such a light is reflected by the intermediate layer, thus exerting an effect that the light in this short wavelength region can be confined in the a-Si unit cell that is the top cell whose absorption coefficient for the light in this short wavelength region is high.

Secondly, with respect to an incident light in a wavelength range near and more than 600nm (a light in a relatively long wavelength region), such a light is not fully absorbed (photoelectrically converted) by the µc-Si unit cell that is the bottom cell, so that a light transmitted therethrough reaches the back surface side of the unit cell. This light is reflected at the reflection interface having the concavo-convex structure at the back surface side according to this embodiment, and is incident again on the bottom cell at a predetermined incident angle. Then, a part of the light is absorbed (photoelectrically converted) by the bottom cell, while the rest of the light reaches an interface between the intermediate layer and the bottom cell and is incident on this interface at a predetermined incident angle. This can achieve a high reflectance. The light reflected with such a high reflectance travels to the bottom cell again. As a result, an effect that the light in the long wavelength range can be effectively confined in the bottom cell is exerted.

Because of these two factors, both the top cell and the bottom cell effectively confine the lights. Therefore, the photocurrent of the photoelectric conversion element 30 is improved.

In a case where the concavo-convex structure at the back surface side according to the present invention is not provided, the light confinement performance in the bottom cell is improved only to a negligible level even though the intermediate layer is provided, as compared with the improvement of the light confinement performance achieved by this embodiment. This is because, when the concavo-convex structure at the back surface side is not provided, the light reflected at the back surface is substantially perpendicularly reflected, and therefore, the reflected light is incident on the bottom cell again in a substantially perpendicular manner, and accordingly the light reflected at the back surface is incident on the interface between the intermediate layer and the bottom cell in a substantially perpendicular manner, too (in general, the smaller the incident angle is, the lower the reflectance becomes to increase the transmissivity).

Here, if the refractive index of the intermediate layer and the refractive index of the light-transmitting member are made close to each other to an equivalent level, the reflectance at the interface between the intermediate layer and the bottom cell can be enhanced, so that the light confinement can be performed more efficiently. Thus, this is suitable for increasing the efficiency. The refractive index of the intermediate layer can be reduced by, for example, increasing the O/Si ratio in a case of a SiO-based intermediate layer. To be more specific, if the oxygen concentration [O] in the film is set to be about 60 at%, the refractive index can be set to be about 1.7 or less, which is the value extremely close to the typical refractive index, about 1.5 or more and 1.6 or less, of the light-transmitting member. In this case, the probability that total reflection will occur at the interface between the intermediate layer and the bottom cell mentioned above increases. Thus, the light confinement performance is improved.

In order to further increase the probability that total reflection will occur at the interface between the intermediate layer and the bottom cell mentioned above, the concavo-convex structure of the light-receiving surface side light-transmitting electrode 31 can be utilized. That is, the formation of each of the layers on this concavo-convex structure reflects such a concavo-convex structure to some extent. Accordingly, each layer interface obtained after the formation of each layer is given a gentle concavo-convex structure that reflects such a concavo-convex structure. When the light reflected at the back surface is incident on the interface between the intermediate layer and the bottom cell where this gentle concavo-convex structure is formed, its incident angle is sometimes greater than that in the above-mentioned case where the concavo-convex structure is not provided between the intermediate layer and the bottom cell. Therefore, the probability that total reflection occurs at this interface increases, and as a result the light confinement performance is improved.

As described above, by combining the structure according to the present invention with the intermediate layer, both of the light confinement efficiency of the top cell and the light confinement efficiency of the bottom cell are simultaneously improved. Therefore, the photocurrent densities in both cells are simultaneously improved. As a result, the energy conversion efficiency of the tandem cell as a whole is improved. Thereby, a thin-film type photoelectric conversion module having a high efficiency is achieved.

<Example 2>

Next, a more specific example of the embodiment 2 will be described.

The photoelectric conversion element was made in the following procedure. As the light-receiving surface side light-transmitting electrode 2, a film of tin oxide ($SnO_2$) having a thickness of about 800nm was formed on white glass having a size of 100mm×100mm and a thickness of 1.8mm by a thermal CVD process. At this time, a concavo-convex structure on a surface of the tin oxide film had an average pitch of about 0.1 $\mu$m or more and 0.5$\mu$m or less and an average height of at most 0.2$\mu$m.

Then, by using a plasma CVD apparatus, photoelectric conversion unit cells were sequentially formed on the light-receiving surface side light-transmitting electrode 2.

As a first-layer unit cell, a unit cell whose i layer was made of a-Si was formed such that its p layer, i layer, and n layer were arranged in that order and had thicknesses of 20nm, 250nm, and 35nm, respectively. Conditions for forming each of the layers were as shown in Table 3. To be specific, the high-frequency power of a PECVD apparatus (Model: CME-200J manufactured by ULVAC, Inc.), the used gases, the gas pressure, and an electrode interval between a cathode electrode and an anode electrode of this apparatus, and the substrate temperature, were as shown in Table 3.

[Table 3]

| | High Frequency Power [W/cm$^2$] | Silane | Hydrogen | Diborane | Methane | Phosphine | Pressure [Pa] | Electrode Interval [mm] | Temperature [°C] |
|---|---|---|---|---|---|---|---|---|---|
| | | | | | [sccm] | | | | |
| p | 0.03 | 10 | 250 | 20 | 10 | --- | 250 | 10 | 200 |
| | 0.03 | 10 | 500 | --- | 10 | --- | 250 | 10 | 200 |
| i | 0.044 | 25 | 250 | --- | --- | --- | 250 | 10 | 180 |
| n | 0.044 | 10 | 200 | --- | --- | 10 | 250 | 10 | 180 |
| | 0.074 | 5 | 500 | --- | --- | 10 | 250 | 10 | 180 |

Moreover, as a second-layer unit cell, a unit cell whose i layer was made of $\mu$c-Si was formed such that its p layer, i layer, and n layer were arranged in that order and had thicknesses of 25nm, 2.5$\mu$m, and 20nm, respectively. Conditions for forming them were as shown in Table 4. To be specific, the high-frequency power of a PECVD apparatus (Model: CME-200J manufactured by ULVAC, Inc.), the used gases, the gas pressure, and an electrode interval between a cathode electrode and an anode electrode of this apparatus, and the substrate temperature, were as shown in Table 3.
[Table 4]

| | High Frequency Power [W/cm$^2$] | Silane | Hydrogen | Diborane | Phosphine | Pressure [Pa] | Electrode Interval [mm] | Temperature [°C] |
|---|---|---|---|---|---|---|---|---|
| | | [sccm] | | | | | | |
| p | 0.34 | 5 | 1000 | 6 | --- | 200 | 10 | 150 |
| i | 0.5 | 18 | 1000 | --- | --- | 800 | 10 | 190 |
| n | 0.044 | 10 | 200 | --- | 10 | 250 | 10 | 170 |

Finally, as the back surface side light-transmitting electrode, a film of aluminum doped zinc oxide (ZnO:Al) having a film thickness of about 100nm was formed on the n-type a-Si layer of the $\mu$c-Si unit cell by means of a sputtering apparatus. Thus, a photoelectric conversion element was completed.

The photoelectric conversion module was made as follows. On the back surface side light-transmitting electrode of the photoelectric conversion element mentioned above, a transparent EVA sheet having a thickness of about 0.4mm and serving as the sealing member and the light-transmitting member was arranged. Thereon, a white acrylic plate having a thickness of about 5mm and provided with a concavo-convex structure as the reflecting member was placed such that the concavo-convex surface was in contact with the transparent EVA sheet. At this time, the following two types of concavo-convex structures were prepared.
1) Concavity and convexity having concave curved surfaces in which the maximum angle was about 35° and an average concavo-convex pitch was about 3$\mu$m (in which the average concavo-convex pitch P and the radius of curvature r satisfy a relationship of P/r = about 1.2) (example module 1)
2) Concavity and convexity having flat slopes in which an angle thereof was in a range of 20° or more and 35° or less (about 30° on average) and an average concavo-convex pitch was about 1mm (example module 2)
3) The one identical to the example module 2 except that an intermediate layer was provided in the element (example module 3)

Here, the above-described intermediate layer was a SiOx film formed by a plasma CVD process using SiH$_4$ gas / CO$_2$ gas / H$_2$ gas as a raw material gas, with a thickness of about 50nm.
Then, a stack of them was set in a laminator apparatus and, while being heated to 120°C or more and 150°C or less under reduced pressure of about 100Pa, pressed for 15 minutes, to integrate the stack. This integrated stack was held in a crosslinking oven at about 150°C under atmospheric pressure for about 60 minutes, to promote a crosslinking reaction of EVA. Thus, the photoelectric conversion module was completed.
Moreover, as comparative photoelectric conversion modules that were to be compared with the above-mentioned photoelectric conversion module, two kinds of modules were made in the same process as described above, in each of which an interface between the light-transmitting member and the reflecting member was as follows.
1) An interface between the light-transmitting member and the reflecting member was flat and parallel to the light-receiving surface without any concavo-convex structure (comparative module A)
2) Slopes of concavity and convexity were flat, with an angle thereof being in a range of 10° or more and 20° or less and an average concavo-convex pitch being about 1mm (comparative module B1)
3) Slopes of concavity and convexity were flat, with an angle thereof being in a range of 35° or more and 45° or less and an average concavo-convex pitch being about 1mm (comparative module B2)
4) Slopes of concavity and convexity were flat, with an angle thereof being about 55° and an average concavo-convex pitch being about 10$\mu$m or more and 20$\mu$m or less (comparative module B3)

Here, a pyramid texture obtained by performing an etching process with an alkaline solution such as a KOH solution on a single crystal Si substrate with (100) orientation in terms of Miller Index was used as a mold for the formation of the concavo-convex structure having the flat slopes with an angle of 55° mentioned above.

The photoelectric conversion modules made in this manner were measured for their output characteristics, under conditions that an element temperature was 25°C and artificial sunlight was given with AM1.5 and 100mW/cm$^2$. Results thereof are shown in Table 5. In the Table, Jsc and Voc indicate the characteristics per cell.

[Table 5]

| | Concavity and Convexity of Back Surface | Jsc [mA/cm$^2$] (Up Rate) | Voc [V] | FF | Efficiency [%] (Up Rate) |
|---|---|---|---|---|---|
| Comparative Module A | None | 12.82 | 1.341 | 0.669 | 11.5 |
| Example Module 1 | Concavity and Convexity having Curved Surface Maximum θ: 35° Pitch: 3μm | 13.97 (9%) | 1.341 | 0.665 | 12.46 (8%) |
| Example Module 2 | Flat Slope θ: 20° to 35° Pitch: 1mm | 14.36 (12%) | 1.341 | 0.664 | 12.79 (11%) |
| Example Module 3 (with intermediate layer) | Flat Slope θ: 20° to 35° Pitch: 1mm | 14.51 (13%) | 1.341 | 0.664 | 12.92 (12%) |
| Comparative Module B 1 | Flat Slope θ: 10° to 20° Pitch: 1mm | 12.85 (0.2%) | 1.341 | 0.669 | 11.53 (0.2%) |
| Comparative Module B2 | Flat Slope θ: 35° to 45° Pitch: 1mm | 13.13 (2%) | 1.341 | 0.668 | 11.76 (2%) |
| Comparative Module B3 | Flat Slope θ: 55° Pitch: 10 to 20μm | 12.84 (0.2%) | 1.341 | 0.669 | 11.52 (0.2%) |

As shown in Table 5, in the example module 1, the Jsc was improved by 9% and the photoelectric conversion efficiency was improved by 8% as compared with the comparative module A. Thus, an effect thereof was confirmed.

In the example module 2, the Jsc was improved by 12% and the photoelectric conversion efficiency was improved by 11 % as compared with the comparative module A. Thus, an effect thereof was confirmed.

In the example module 3, the Jsc was improved by 13% and the photoelectric conversion efficiency was improved by 12% as compared with the comparative module A. Thus, an effect thereof was confirmed.

In the comparative modules B1 to B3, it was confirmed that, even though a concavo-convex structure was provided, little improvement of the photoelectric conversion efficiency was recognized, or else, just a little was recognized. This validates the TIRAFS principle described above. That is, it can be construed that, even though the concavo-convex structure was provided, the angle thereof was out of the condition range claimed in this embodiment and therefore a totally-reflected-light confinement could not be achieved at the light-receiving surface of the module, so that little improvement of the efficiency was recognized or, if any, just a little improvement could be recognized.

<Embodiment 3>

Next, a description will be given to another embodiment of the photoelectric conversion module including the crystalline type photoelectric conversion element. FIG. 27 shows a partial cross-sectional view of a photoelectric conversion module 40. As shown in FIG. 27, the light-transmitting substrate 22 is made of glass, a light-transmitting resin, or the like, as already described. The light-transmitting member 25 is a transparent plate-shaped member made of acrylic resin, polycarbonate resin, or the like, and is provided at the back surface side thereof with a concavo-convex structure having predetermined inclined slopes.

As the reflecting member 26, a white plate-shaped member made of acrylic resin, polycarbonate resin, or the like, is used. At the light-receiving surface side thereof, a concavo-convex structure fittable with the concavo-convex structure provided at the back surface side of the light-transmitting member 25 is provided.

The light-transmitting member 25 and the reflecting member 26 are bonded to each other in a fitted state, by a light-transmitting adhesive being applied to the entire surfaces of them or to outer peripheral portions of them.

In the light-transmitting substrate 22 and the light-transmitting member 25, element fixing members 41 are preliminarily provided at positions where the photoelectric conversion element will be arranged. The number of points of the element fixing members 41 is about two or more and nine or less per each photoelectric conversion element 1. For the element fixing member 41, an elastic body made of a resin, such as acrylic rubber, nitrile rubber, urethane rubber, or silicone rubber, may be used.

The photoelectric conversion element 1 is fixed by being sandwiched from both sides thereof by the element fixing members 41 provided in the light-transmitting substrate 22 and the light-transmitting member 25. Then, the light-transmitting substrate 22 and the light-transmitting member 25 are bonded to each other by an adhesive being applied to outer peripheral portions of them. Thus, a gap 42 between the light-transmitting substrate 22 and the light-transmitting member 25 is filled with an inert gas such as a nitrogen or argon gas, in order to suppress an entry of air or an oxidation of the photoelectric conversion element 1 or the connection wiring 21.

Such a structure makes it unnecessary to use a member made of EVA or the like as the light-receiving surface side sealing member or as the back surface side sealing member, and can also omit the laminating step and the like. Thus, a solar cell module having a high efficiency can be easily provided.

<Embodiment 4>

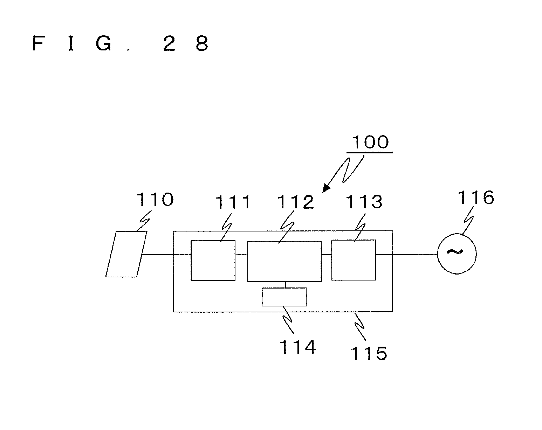

Next, a description will be given to a power generation device according to one embodiment of the present invention. For example, as shown in FIG. 28, a power generation device 100 comprises a photoelectric conversion module group (for example, a solar cell array) 110 in which one or more photoelectric conversion modules described above are electrically connected, and an electric power conversion apparatus 115 to which DC power of the photoelectric conversion module group is inputted.

For example, the electric power conversion apparatus 115 comprises an input filter circuit 111, an electric power convert circuit 112, an output filter circuit 113, and a control circuit 114. Such a configuration enables commercial electric power from the electric power conversion apparatus 115 to be inputted to the commercial power supply system 116. In this power generation device 100, the photoelectric conversion module comprised therein has a high efficiency, and therefore an excellent power generation device having a high efficiency, such as a photovoltaic power generation apparatus, can be provided.

DESCRIPTION OF THE REFERENCE NUMERALS

1: photoelectric conversion element
2: semiconductor substrate
3: light-receiving surface side bus-bar electrode
4: light-receiving surface side finger electrode
5: anti-reflection film
6: passivation film
7: back surface side bus-bar electrode
8: back surface side finger electrode
10: BSF layer
11: transparent conductive film
20, 30: photoelectric conversion module
22, 61: light-transmitting substrate
22a, 61a: first surface
22b, 61b: second surface
62: front transparent electrode
65: back transparent electrode
66: light-transmitting member
67: reflecting member
67a: light reflection surface
100: power generation device
110: photoelectric conversion module group
115: electric power conversion apparatus

**Claims**

1. A photoelectric conversion module comprising: a light-transmitting substrate comprising a first surface on which a light is incident and a second surface located at the opposite side of the first surface; a photoelectric conversion element positioned on the second surface; a light-transmitting member positioned on the photoelectric conversion element; and a reflecting member positioned on the light-transmitting member and configured to reflect a light having been transmitted through the light-transmitting member, wherein
in order to cause a light reflected from the reflecting member to be totally reflected at the first surface of the substrate, the reflecting member comprises a light reflection surface with a concavo-convex shape that is provided with a plurality of chevron-shaped surfaces each inclined at a predetermined angle relative to the first surface.

2. The photoelectric conversion module according to claim 1, wherein
when the refractive index of the light-transmitting member is defined as n, an angle $\theta$ formed between the light reflection surface of the reflecting member and the first surface of the substrate satisfies the following expression:

$$43.7-14.9 \times n \leq \theta \leq 22.8+7.4 \times n.$$

3. A photoelectric conversion module comprising: a light-transmitting substrate comprising a first surface on which a light is incident and a second surface located at the opposite side of the first surface; a photoelectric conversion element positioned on the second surface; a light-transmitting member positioned on the photoelectric conversion element; and a reflecting member positioned on the light-transmitting member and configured to reflect a light having been transmitted through the light-transmitting member, wherein
in order to cause a light reflected from the reflecting member to be totally reflected at the first surface of the substrate, the reflecting member comprises a light reflection surface with a concavo-convex shape that is provided with a plurality of curved concave surfaces or curved convex surfaces.

4. The photoelectric conversion module according to claim 3, wherein
when an average radius of curvature of the curved concave surface or the curved convex surface is defined as r, and an average distance between adjacent convex portions or adjacent concave portions in the repeated concavo-convex shape is defined as P, the following expression is satisfied:

$$0.7 \leq P/r \leq 2.0.$$

5. The photoelectric conversion module according to any one of claims 1 to 4, wherein
the photoelectric conversion element comprises an amorphous silicon layer.

6. A method for manufacturing the photoelectric conversion module according to any one of claims 1 to 5, wherein
the light reflection surface is formed by means of transfer to the reflecting member by using a mold.

7. A power generation device comprising, as power generation means, one or more the photoelectric conversion modules according to any one of claims 1 to 5.

8. A power generation device comprising: power generation means comprising one or more the photoelectric conversion modules according to any one of claims 1 to 5; and power conversion means for converting DC power from the power generation means into AC power.

F I G . 1

FIG. 2

(a)

(b)

F I G . 3

RANGE OF ANGLE θ OF TRANSPARENT
MEMBER FOR ENABLING ACHIEVEMENT
OF TIRAFS [Deg.]

y = 7.4 x + 22.8

RANGE WHERE
TIRAFS IS ACHIEVED

y = −14.9 x + 43.7

■ θ UPPER LIMIT

◆ θ LOWER LIMIT

REFRACTIVE INDEX n OF TRANSPARENT MEMBER

F I G . 4

REFLECTANCE IN CASE WHERE BACK TRANSPARENT
CONCAVO-CONVEX MEMBER HAS CURVED CONCAVE STRUCTURE

REFLECTANCE

CONCAVO-CONVEX PITCH P / RADIUS OF CURVATURE r

F I G . 5

( a )

( b )

( c )

# F I G . 6

(a)

(a)

(c)

F I G . 7

F I G . 8

1

2

6

7     8

F I G . 9

1

9  2b     3        5

2a  2        6      7

F I G . 1 0

(a)

8

7

6

(b)

8

7

6

F I G . 1 1

1

2

B          B

10          7          11

F I G . 1 2

1

9    2a    3         5
     2b

10    11         6    7
         2

F I G . 1 3

F I G . 1 4

F I G . 1 5

FIG. 16

FIG. 17

FIG. 18

20

22a  22b   23   22

1       23        25 26    27
               24

FIG. 19

20

22a  22b   23   22

1    28        25 26   27
              24

FIG. 20

FIG. 21

F I G . 2 2

26

F I G . 2 3

26

r

θ

P

FIG. 24

(a)　　　　　(b)

FIG. 25

F I G . 2 6

30

34  33  22b  32  31  22a  22

35  25  26  27

F I G . 2 7

4

22  41  21  1

42

26  25

FIG. 28

**INTERNATIONAL SEARCH REPORT**

| International application No. |
| --- |
| PCT/JP2010/071380 |

A. CLASSIFICATION OF SUBJECT MATTER
*H01L31/052*(2006.01)i, *H01L31/042*(2006.01)i

According to International Patent Classification (IPC) or to both national classification and IPC

B. FIELDS SEARCHED

Minimum documentation searched (classification system followed by classification symbols)
H01L31/00-31/20

Documentation searched other than minimum documentation to the extent that such documents are included in the fields searched
Jitsuyo Shinan Koho          1922-1996    Jitsuyo Shinan Toroku Koho    1996-2010
Kokai Jitsuyo Shinan Koho    1971-2010    Toroku Jitsuyo Shinan Koho    1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2001-119054 A  (Hitachi, Ltd.), 27 April 2001 (27.04.2001), (Family: none) | 1-8 |
| X | JP 2002-26364 A  (Hitachi, Ltd.), 25 January 2002 (25.01.2002), (Family: none) | 1-8 |
| X | US 2006/0272698 A1  (Durvasula), 07 December 2006 (07.12.2006), & EP 1732141 A1          & CN 1877865 A & JP 2006-344964 A | 1-8 |
| X | US 6008449 B1  (Cole), 28 December 1999 (28.12.1999), & WO 1999/009601 A1      & AU 8830598 A & EP 1019969 A          & JP 2001-516149 A | 1-8 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 22 December, 2010 (22.12.10) | 11 January, 2011 (11.01.11) |

| Name and mailing address of the ISA/ Japanese Patent Office | Authorized officer |
| --- | --- |
| Facsimile No. | Telephone No. |

Form PCT/ISA/210 (second sheet) (July 2009)

**INTERNATIONAL SEARCH REPORT**

International application No.

PCT/JP2010/071380

C (Continuation).   DOCUMENTS CONSIDERED TO BE RELEVANT

| Category* | Citation of document, with indication, where appropriate, of the relevant passages | Relevant to claim No. |
|---|---|---|
| X | JP 10-284747 A  (Sharp Corp.),<br>23 October 1998 (23.10.1998),<br>(Family: none) | 1-8 |
| Y | US 7238878 B2  (Gonsiorawski),<br>03 July 2007 (03.07.2007),<br>& US 6660930 B1          & WO 2003/107438 A1<br>& WO 2003/107439 A1      & AU 2003228601 A<br>& AU 2003243479 A        & US 2008/0000517 A1 | 1-8 |
| Y | JP 2000-294818 A  (Sony Corp.),<br>20 October 2000 (20.10.2000),<br>& EP 1043779 A2          & KR 10-2001-0014686 A<br>& US 6350945 B1 | 1-8 |
| Y | US 3973994 A  (Redfield),<br>10 August 1976 (10.08.1976),<br>& DE 2509533 A          & JP 50-123286 A<br>& FR 2264399 A          & AU 7880275 A<br>& GB 1489318 A          & CA 1021445 A | 1-8 |
| Y | US 5261970 A  (Landis),<br>16 November 1993 (16.11.1993),<br>(Family: none) | 1-8 |
| P,X | WO 2010/038482 A1  (Toppan Printing Co., Ltd.),<br>08 April 2010 (08.04.2010),<br>& JP 2010-92899 A        & JP 2010-123718 A | 1-8 |
| P,X | WO 2010/058589 A1  (Toppan Printing Co., Ltd.),<br>27 May 2010 (27.05.2010),<br>(Family: none) | 1-8 |
| P,X | WO 2010/084837 A1  (Toyota Motor Corp.),<br>29 July 2010 (29.07.2010),<br>& JP 2010-171277 A | 1-8 |

Form PCT/ISA/210 (continuation of second sheet) (July 2009)

**REFERENCES CITED IN THE DESCRIPTION**

**Patent documents cited in the description**

- JP 2106077 A
- JP 5075154 A
- JP 7131040 A
- JP 2002299661 A
- JP 2003298088 A